# EUROPÄISCHE PATENTSCHRIFT

(11) **EP 0 670 323 B1**
(45) Veröffentlichungstag und Bekanntmachung des Hinweises auf die Patenterteilung: **28.06.2000**
(21) Anmeldenummer: 95810102.4
(22) Anmeldetag: 17.02.1995
(51) Int. Cl.: C07F 9/50, C08F 2/50, G03F 7/029, C07F 9/53

(54) **Dimere Bisacylphosphine, -oxide und -sulfide**
Dimeric bisacylphosphines, bisacylphosphine oxides and bisacylphosphine sulfides
Bisacylphosphines, oxydes et sulfures de bisacylphosphines dimères

(30) Priorität: 02.03.1994 CH 61494
(43) Veröffentlichungstag der Anmeldung: 06.09.1995
(73) Patentinhaber: Ciba Specialty Chemicals Holding Inc., 4057 Basel (CH)
(72) Erfinder: Leppard, David G., Dr., CH-1723 Marly (CH); Köhler, Manfred, Dr., D-79108 Freiburg (DE)

(56) Entgegenhaltungen:
- EP-A- 0 184 095
- EP-A- 0 495 751
- EP-A- 0 495 752
- CHEMICAL ABSTRACTS, vol. 119, no. 8, 23. August 1993, Columbus, Ohio, US; abstract no. 074134, UEDA T ET AL 'Photocurable compositions for viscoelastic polymers' & JP-A-92 239 508 (SEKISUI CHEMICAL CO., LTD.;JAPAN ) 27. August 1992
- CHEMICAL ABSTRACTS, vol. 090, no. 11, 12. März 1979, Columbus, Ohio, US; abstract no. 087589, LINDNER E ET AL 'Bifunctional acyl(diorganyl)phosphanes and their behavior towards molecular oxygen' & Z. NATURFORSCH., B: ANORG. CHEM., ORG. CHEM. (ZNBAD2,03405087);78; VOL.33B (12); PP.1457-60, UNIV. TUEBINGEN;INST. ANORG. CHEM.; TUEBINGEN; GER.

## Beschreibung

Die Erfindung betrifft dimere Bisacylphosphin-, -sulfid- und -oxid-Verbindungen, Zusammensetzungen enthaltend diese Verbindungen und die Verwendung der Verbindungen als Photoinitiatoren zur Photopolymerisation von ethylenisch ungesättigten Verbindungen.

Die Verwendung von Bisacylphosphinoxiden als Photoinitiatoren ist aus der EP-A-184 095 bekannt. Bisacylphosphine sind in der EP-A-495 751 beschrieben. Bisacylphosphinsulfide sind in der EP-A-495 752 offenbart. Dimere Monoacylphosphin-oxide als Photoinitiatoren sind in Chemical Abstracts Bd. 119(8), Nr. 74134u beschrieben. E. Lindner und G. Vordermeier berichten in der Z. Naturforsch. 33b, 1457-1469 (1978) über das Verhalten von bifunktionellen Acyl(diorganyl)phosphanen gegenüber Sauerstoff. Auch bei den dort offenbarten Acylphosphinoxiden handelt es sich um dimere Monoacylphosphinoxid Verbindungen. E.L. Gefter und I.A. Rogacheva veröffentlichten in Zhurnal Obshchei Khimii, Vol. 36, No 1, 79-81 (1966) die Synthese von Ethylenglycolestern von Phosphorsäureestern. Die hier beschriebenen Verbindungen sind auch dimere Monoacylphosphinoxide.

Für den umfangreichen Anwendungsbereich von Photoinitiatoren besteht weiterhin ein Bedarf an wirksamen Verbindungen.

Es wurde gefunden, dass dimere Bisacylphosphine, -sulfide und -oxide wirksame Photoinitiatoren sind.

Gegenstand der Erfindung sind daher Verbindungen der Formel I, 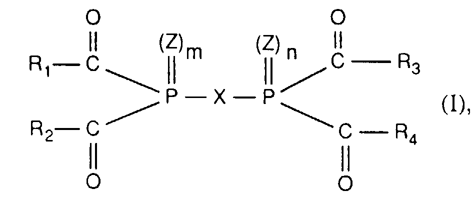 worin
Z für Sauerstoff oder Schwefel steht,
n und m unabhängig voneinander 0 oder 1 bedeuten,
R₁, R₂, R₃ und R₄ unabhängig voneinander für C₁-C₂₀-Alkyl, Cyclopropyl, Cyclopentyl, Cyclohexyl, C₂-C₈-Alkenyl, unsubstituiertes oder ein- bis vierfach mit C₁-C₁₂-Alkyl, C₁-C₁₂-Alkoxy, C₁-C₆-Alkylthio und/oder Halogen substituiertes Phenyl, unsubstituiertes oder ein- bis vierfach mit C₁-C₁₂-Alkyl, C₁-C₁₂-Alkoxy, C₁-C₆-Alkylthio und/oder Halogen substituiertes Naphthyl, unsubstituiertes oder ein- bis vierfach mit C₁-C₁₂-Alkyl, C₁-C₁₂-Alkoxy, C₁-C₆-Alkylthio und/oder Halogen substituiertes Biphenyl stehen, oder R₁, R₂, R₃ und R₄ unabhängig voneinander für einen O-, S- oder N-haltigen 5- oder 6-gliedrigen heterocyclischen Ring stehen oder R₁ und R₂ oder/und R₃ und R₄ zu einem 4 bis 10 Kohlenstoffatome enthaltenden Ring verknüpft sind, der unsubstituiert oder mit 1 bis 6 C₁-C₄-Alkylgruppen substituiert ist,
X für lineares oder verzweigtes C₁-C₁₈-Alkylen,
ein- oder mehrmals durch -O-, -S-, -NR₅-, -P(O)R₆- oder -SO₂- unterbrochenes C₂-C₁₈-Alkylen, mit Cl, F, C₁-C₄-Alkoxy, COOR₇, Phenyl, C₁-C₄-Alkyl-phenyl, C₁-C₄-Alkyl-naphthyl, Phenyl-C₁-C₄-alkyl, Naphthyl-C₁-C₄-alkyl, Phenyl-C₁-C₄-alkoxy, Naphthyl-C₁-C₄-alkoxy, C₁-C₄-Alkoxy-C₁-C₄-alkoxy und/oder CN substituiertes C₁-C₆-Alkylen steht, oder X C₂-C₈-Alkylen, welches mit einer oder zwei Gruppen der Formel G 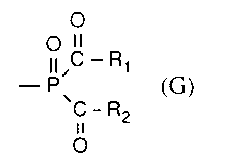 substituiert ist, bedeutet, oder X für eine Gruppe der Formel (II), (III), (IV), (V), (VI), (VII), (VIII), (IX) oder (X) 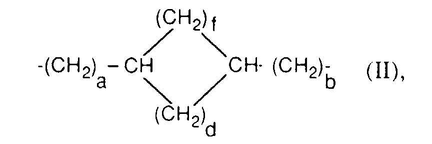 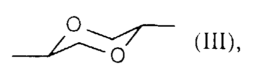 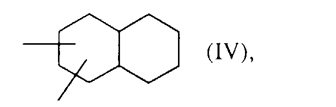 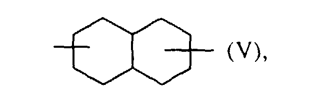 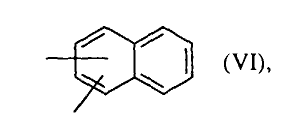 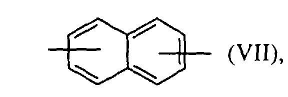 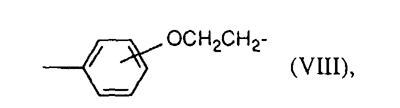 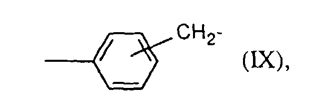 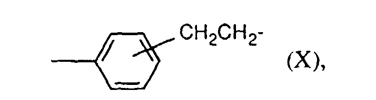 steht, worin
a und b unabhängig voneinander 0 oder 1 bedeuten,
die Summe von d und f 3 bis 8 ist, wobei weder d noch f 0 sind,
oder X eine Gruppe -CH₂-CH=CH-CH₂- oder -CH₂-C≡C-CH₂- bedeutet,
oder X für unsubstituiertes oder ein- bis dreifach mit Cl, F, C₁-C₄-Alkyl und/oder C₁-C₄-Alkoxy substituiertes Phenylen, Xylylen, 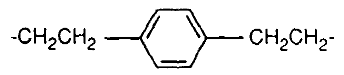 oder 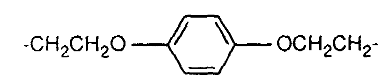 steht, oder X mit ein bis zwei Gruppen G substituiertes Phenylen ist, welches ausserdem noch ein- bis dreifach mit Cl, F, C₁-C₄-Alkyl und/oder C₁-C₄-Alkoxy substituiert sein kann, oder X eine Gruppe der Formel (XI), (XII), (XIII) oder (XIV) ist 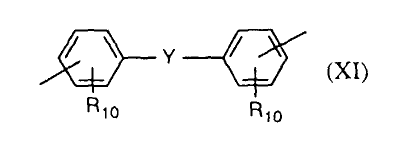 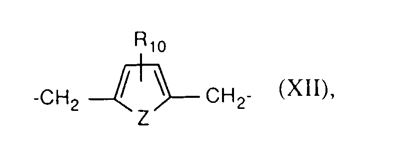 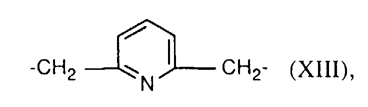 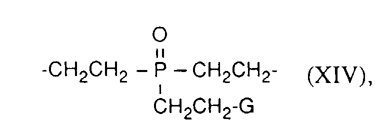 worin
Z und G wie oben definiert sind und
Y eine Einfachbindung, -CR₈R₉-, -O-, -NR₅-, -S-, -SO₂-, -(CH₂)ₚ- oder -CH=CH- ist,
p für eine Zahl von 2 bis 12 steht,
R₅ Wasserstoff, C₁-C₁₂-Alkyl oder Phenyl bedeutet,
R₆ C₁-C₄-Alkyl oder Phenyl ist,
R₇ für C₁-C₁₂-Alkyl, mit einem oder mehreren O unterbrochenes C₂-C₁₈-Alkyl, Benzyl, Phenyl, Cyclopentyl oder Cyclohexyl steht, und
R₈ Wasserstoff, Methyl oder Ethyl ist,
R₉ Wasserstoff oder C₁-C₄-Alkyl bedeutet und
R₁₀ für C₁-C₄-Alkyl, C₁-C₄-Alkoxy oder Halogen steht.

R₁, R₂, R₃, und R₄ als C₁-C₂₀-Alkyl sind lineare oder verzweigte Reste und bedeuten z.B. Methyl, Ethyl, Propyl, Isopropyl, n-Butyl, sec-Butyl, iso-Butyl, tert-Butyl, Pentyl, Hexyl, Heptyl, 2,4,4-Trimethylpentyl, 2-Ethylhexyl, Octyl, Nonyl, Decyl, Dodecyl, Tetradecyl, Heptadecyl, Octadecyl, Nonadecyl oder Icosyl. Beispielsweise sind R₁, R₂, R₃ und R₄ C₁-C₁₈-Alkyl, insbesondere C₁-C₁₂-Alkyl. Bevorzugt sind sekundäres oder tertiäres C₃-C₁₈- bzw. C₃-C₁₂-Alkyl, insbesondere tert-C₄-C₈-Alkyl.

R₅ und R₇ als C₁-C₁₂-Alkyl und R₆, R₉ und R₁₀ als C₁-C₄-Alkyl haben die gleichen Bedeutungen wie für R₁, R₂, R₃ und R₄ angegeben, bis zur entsprechenden Anzahl der C-Atome. R₅ und R₇ sind z.B C₁-C₈-Alkyl, insbesondere C₁-C₄-Alkyl. R₆ ist insbesondere Methyl.

R₁, R₂, R₃, und R₄ als C₂-C₈-Alkenyl sind beispielsweise Allyl, Methallyl, 1,1-Dimethylallyl, Butenyl, Hexenyl oder Octenyl, insbesondere Allyl.

R₁₀ als C₁-C₄-Alkoxy bedeutet z.B. Methoxy, Ethoxy, n-Propoxy, i-Propoxy, n-Butoxy, i-Butoxy, s-Butoxy oder t-Butoxy, insbesondere Methoxy.

Substituiertes Phenyl, Naphthyl oder Biphenyl ist ein- bis vierfach, z.B. ein-, zwei- oder dreifach, insbesondere zwei- oder dreifach substituiert.

R₁, R₂, R₃, und R₄ als substituiertes Phenyl, Naphthyl oder Biphenyl sind z.B. mit linearem oder verzweigtem C₁-C₁₂-Alkyl wie Methyl, Ethyl, n-Propyl, i-Propyl, n-Butyl, i-Butyl, s-Butyl, t-Butyl, Pentyl, Hexyl, Heptyl, Octyl, Nonyl, Decyl oder Dodecyl oder mit linearem oder verzweigtem C₁-C₁₂-Alkoxy wie Methoxy, Ethoxy, n-Propoxy, i-Propoxy, n-Butoxy, i-Butoxy, s-Butoxy, t-Butoxy, Hexyloxy, Octyloxy, Nonyloxy, Decyloxy oder Dodecyloxy oder mit linearem oder verzweigtem C₁-C₆-Alkylthio wie Methylthio, Ethylthio, n-Propylthio, i-Propylthio, n-Butylthio, i-Butylthio, s-Butylthio, t-Butylthio, Pentylthio oder Hexylthio oder mit Halogen wie Fluor, Chlor, Brom oder Iod substituiert.
Bevorzugte Substituenten für R₁, R₂, R₃, und R₄ als Phenyl, Naphthyl und Biphenyl sind C₁-C₄-Alkyl, insbesondere Methyl, C₁-C₄-Alkoxy, insbesondere Methoxy, und Chlor. Besonders bevorzugt sind R₁, R₂, R₃ und R₄ z.B. 2,4,6-Trimethylphenyl, 2,6-Dichlorphenyl, 2,6-Dimethylphenyl oder 2,6-Dimethoxyphenyl.

R₁, R₂, R₃, und R₄ als O-, S- oder N-haltiger 5- oder 6-gliedriger heterocyclischer Ring bedeuten z.B. Furyl, Thienyl, Pyrrolyl oder Pyridyl. Die genannten heterocyclischen Reste können ein- oder mehrfach, z.B. ein- oder zweifach, mit linearem oder verzweigtem C₁-C₆-Alkyl wie Methyl, Ethyl, Propyl, Butyl, Pentyl oder Hexyl, insbesondere C₁-C₄-Alkyl, substituiert sein. Beispiele dafür sind Dimethylpyridyl, Dimethylpyrrolyl oder Methylfuryl.

Sind R₁ und R₂ oder/und R₃ und R₄ zu einem 4-10 Kohlenstoffatome enthaltenden Ring verknüpft, so kann dieser das P-Atom und die beiden Carbonyl-C-Atome, an welche R₁ und R₂ bzw. R₃ und R₄ gebunden sind mit einbeziehen. Dann ergeben sich beispielsweise Strukturelemente wie 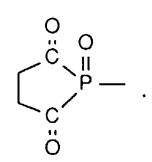 Der Ring kann jedoch auch den beiden Carbonyl-C-Atomen benachbart sein. In solchen Fällen kann der Ring aliphatisch oder aromatisch sein, und ist z.B. Cyclohexyl oder Benzyl. Es handelt sich dann z.B. um folgende Struktureinheiten 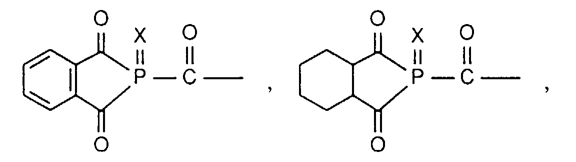 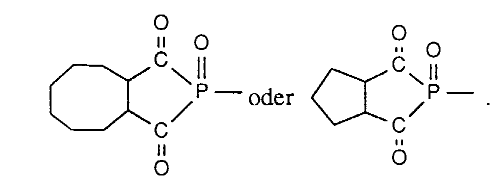 Sind diese Reste mit C₁-C₆-Alkyl substituiert, so handelt es sich um lineare oder verzweigte Reste wie z.B. Methyl, Ethyl, n-Propyl, i-Propyl, n-Butyl, i-Butyl, s-Butyl, t-Butyl, Pentyl oder Hexyl, vorzugsweise Methyl.

Y als -(CH₂)ₚ- ist vorzugsweise -CH₂CH₂-.

X als C₁-C₁₈-Alkylen ist lineares oder verweigtes Alkylen wie z.B. Methylen, Ethylen, Propylen, Isopropylen, n-Butylen, sec-Butylen, iso-Butylen, tert-Butylen, Pentylen, Hexylen, Heptylen, Octylen, Nonylen, Decylen, Dodecylen, Tetradecylen, Heptadecylen oder Octadecylen. Insbesondere ist X C₁-C₁₂-Alkylen, z.B. Ethylen, Decylen, 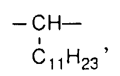 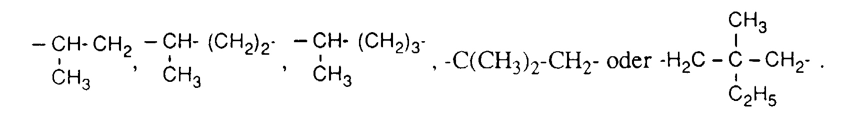 Ist X als C₂-C₁₈-Alkylen unterbrochen mit -O-, -S-, -NR₅-, -P(O)R₆- oder -SO₂- ergeben sich z.B. Struktureinheiten wie -CH₂-O-CH₂-, -CH₂CH₂-O-CH₂CH₂-, -[CH₂CH₂O]_{y}-, mit y = 1-9,-(CH₂CH₂O)₇CH₂CH₂-,-CH₂-CH(CH₃)-O-CH₂-CH(CH₃), -CH₂-S-CH₂-, -CH₂CH₂-S-CH₂CH₂-, -CH₂CH₂CH₂-S-CH₂CH₂CH₂-, -(CH₂)₃-S-(CH₂)₃-S-(CH₂)₃-, -CH₂-(NR₅)-CH₂-, -CH₂CH₂-(NR₅)-CH₂CH₂-, -CH₂-(P(O)R₆)-CH₂-, 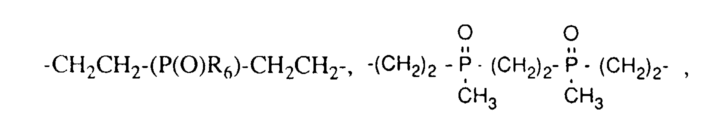 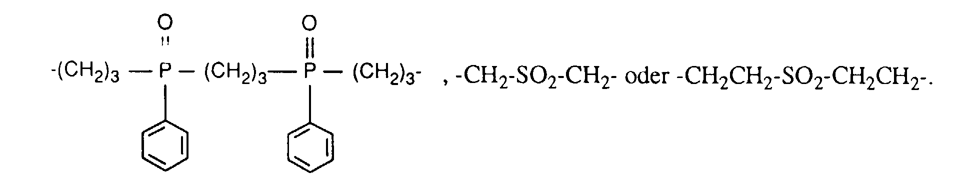
C₁-C₄-Alkoxy Substituenten sind z.B. Methoxy, Ethoxy, Propoxy oder Butoxy, insbesondere Methoxy. Mit C₁-C₄-Alkoxy oder -COOR₇ substituiertes C₁-C₆-Alkylen ist z.B. 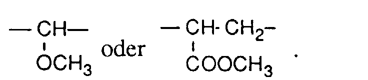
C₁-C₄-Alkylphenyl ist beispielsweise Tolyl, Xylyl, Mesityl, Ethylphenyl, Diethylphenyl, vorzugsweise Tolyl oder Mesityl.
C₁-C₄-Alkylnaphthyl ist mit Methyl, Ethyl und/oder Propyl oder Butyl substituiertes Naphthyl.
Phenyl-C₁-C₄-alkyl bedeutet z.B. Benzyl, Phenylethyl, α-Methylbenzyl oder α,α-Dimethylbenzyl, insbesondere Benzyl.
Naphthyl-C₁-C₄-alkyl ist z.B. Naphthylmethyl, Naphthylethyl,
Naphthyl-(1-methyl)eth-1-yl oder Naphthyl-(1,1-dimethyl)eth-1-yl, insbesondere Naphthylmethyl.
C₁-C₄-Alkylphenyl-C₁-C₄-alkyl ist beispielsweise 2,4,6-Trimethylbenzyl, 2,6-Dimethylbenzyl, 2,4,6-Trimethylphenylethyl, 4-Methylbenzyl oder 4-Methylphenylethyl, insbesondere 2,4,6-Trimethylbenzyl.
Unter Phenyl-C₁-C₄-alkoxy ist beispielsweise Benzyloxy, Phenylethyloxy, α-Methylbenzyloxy oder α,α-Dimethylbenzyloxy, insbesondere Benzyloxy zu verstehen. Naphthyl-C₁-C₄-alkoxy ist z.B. Naphthylmethyloxy oder Naphthylethyloxy, C₁-C₄-Alkoxy-C₁-C₄-alkoxy bedeutet beispielsweise Methoxyethoxy, Methoxypropoxy, Methoxybutoxy, Ethoxymethoxy, Ethoxyethoxy, Ethoxypropoxy, Ethoxybutoxy, Propoxymethoxy, Propoxyethoxy, Propoxypropoxy, Propoxybutoxy, Butoxymethoxy, Butoxyethoxy, Butoxypropoxy oder Butoxybutoxy, insbesondere Methoxyethoxy und Ethoxyethoxy.

Beispiele für mit einer oder zwei Gruppen (G) substituiertes C₂-C₈-Alkylen sind: 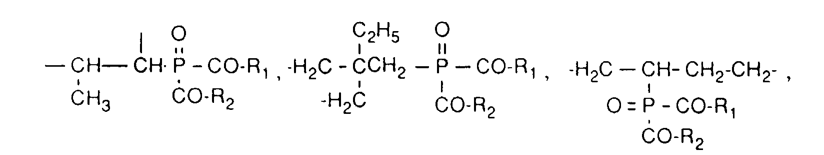 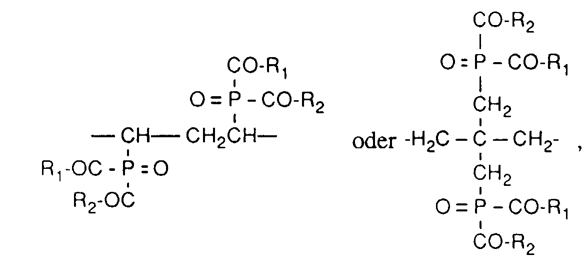 wobei R₁ und R₂ wie oben definiert sind.

Beispiele für X als mit Cl, F, Phenyl, C₁-C₄-Alkoxy-C₁-C₄-alkoxy, Phenyl-C₁-C₄-alkyl, Phenyl-C₁-C₄-alkoxy und C₁-C₄-Alkylphenyl-C₁-C₄-alkyl substituiertes C₁-C₁₈-Alkylen sind: 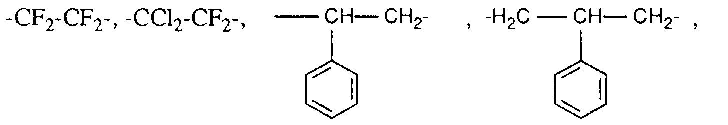 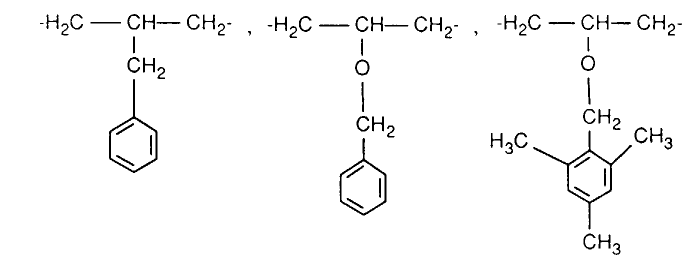 oder

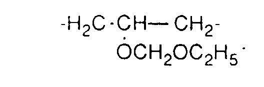

Beispiele für Gruppen der Formel (II), worin die Summe von d und f 3 bis 8 ist, sind:

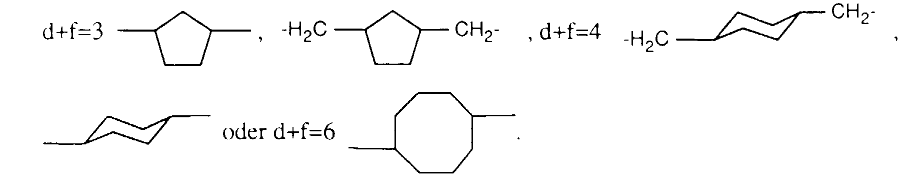

Bevorzugt sind

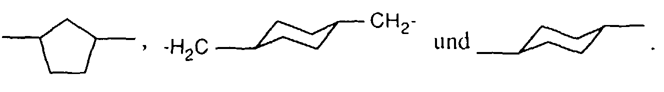

Als C₁-C₄-Alkyl und C₁-C₄-Alkoxy Substituenten für Phenylen oder Xylenen kommen z.B. Methyl, Ethyl, n-Propyl, iso-Propyl, n-Butyl, tert-Butyl, i-Butyl, s-Butyl, Methoxy, Ethoxy, Propoxy, oder Butoxy, insbesondere Methyl und Methoxy, in Frage. Beispiele für unsubstituiertes und substituiertes Phenylen oder Xylylen sind

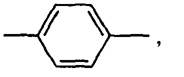

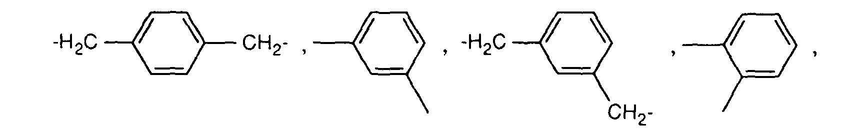

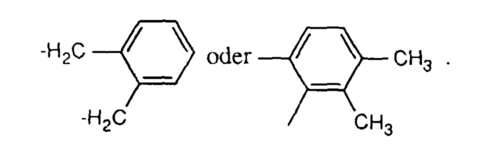

Beispiele für mit G substituiertes Phenylen sind:

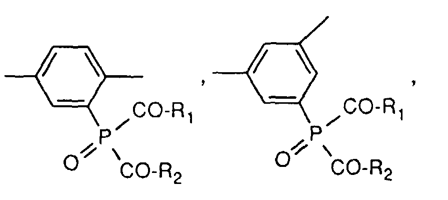

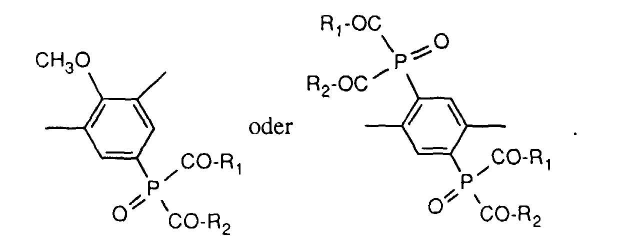

Bei dem Ring in der Formel XII handelt es sich entweder um einen Thiophen- oder um einen Furanring.

Beispiele für Gruppen der Formeln (V), (VI), (VII) und (X) sind

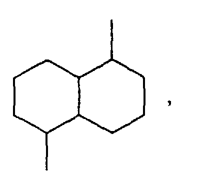

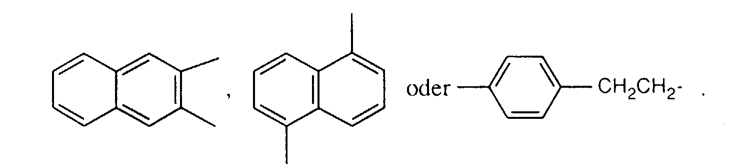

Beispiele für die Gruppe der Formel (XI) sind 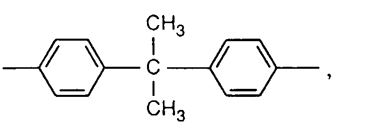 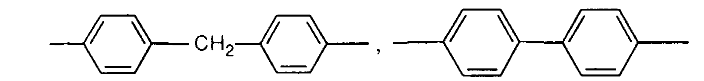 oder

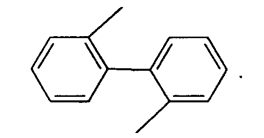

R₈ und R₇ als C₁-C₁₂-Alkyl und R₉ als C₁-C₄-Alkyl können die gleichen Bedeutungen haben wie für R₁, R₂, R₃ und R₄ angegeben, bis zur entsprechenden Anzahl der C-Atome.

R₇ als mit O unterbrochenes C₂-C₁₈-Alkyl ist z.B. Methoxymethyl, Ethoxymethyl, Methoxyethyl, Ethoxyethyl oder Struktureinheiten der Formeln CH₃CH₂O-[CH₂CH₂O]_{y}-, mit y = 1-14, insbesondere Methoxymethyl.

Halogen steht für Fluor, Chlor, Brom und Iod, z.B. Brom und Chlor, insbesondere Chlor.

Bevorzugt sind Verbindungen der Formel I, worin
R₁, R₂, R₃ und R₄ für tert-C₄-C₈-Alkyl, Cyclopentyl, Cyclohexyl, für einen Rest 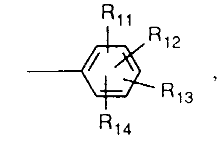 worin
R₁₁ C₁-C₈-Alkyl, C₁-C₈-Alkoxy, C₁-C₄-Alkylthio oder Halogen ist,
R₁₂, R₁₃ und R₁₄ unabhängig voneinander Wasserstoff, C₁-C₈-Alkyl, C₁-C₈-Alkoxy, C₁-C₄-Alkylthio oder Halogen sind, stehen
oder R₁, R₂, R₃ und R₄ für unsubstituiertes oder ein- bis vierfach mit C₁-C₈-Alkyl, C₁-C₈-Alkoxy, C₁-C₄-Alkylthio und/oder Halogen substituiertes Naphthyl, unsubstituiertes oder ein- bis vierfach mit C₁-C₈-Alkyl, C₁-C₈-Alkoxy, C₁-C₄-Alkylthio und/oder Halogen substituiertes Biphenyl stehen, oder R₁, R₂, R₃ und R₄ unabhängig voneinander für einen O-, S- oder N-haltigen 5- oder 6-gliedrigen heterocyclischen Ring stehen oder R₁ und R₂ und R₃ und R₄ zu einem Benzolring verknüpft sind, wobei jeweils R₁ und R₂ sowie R₃ und R₄ ortho zueinander stehen,
X für lineares oder verzweigtes C₁-C₁₈-Alkylen, ein- oder mehrmals durch -O-, -S-, oder -SO₂- unterbrochenes C₄-C₁₈-Alkylen, mit Cl, F, Methoxy, COOCH₃, Phenyl, C₁-C₄-Alkyl-phenyl oder Phenyl-C₁-C₄-alkyl substituiertes C₁-C₄-Alkylen steht, oder X C₂-C₈-Alkylen, welches mit einer oder zwei Gruppen der Formel G substituiert ist, bedeutet, oder X für eine Gruppe der Formel (II), (IX), (X) oder (XI) steht, oder X eine Gruppe -CH₂-CH=CH-CH₂- oder -CH₂-C≡C-CH₂- bedeutet, oder X für unsubstituiertes oder ein- bis dreifach mit Cl, F, C₁-C₄-Alkyl und/oder C₁-C₄-Alkoxy substituiertes Phenylen, Xylylen, 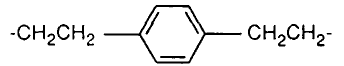 oder 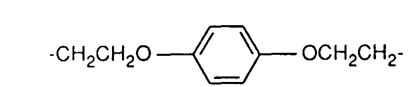 steht, oder X mit ein bis zwei Gruppen G substituiertes Phenylen ist, oder X eine Gruppe der Formel (XIV) darstellt,
Y eine Einfachbindung, -CR₈R₉-, -O-, -S-, -SO₂-, -CH₂CH₂- oder -CH=CH- ist und R₈ und R₉ unabhängig voneinander Wasserstoff oder Methyl sind.

Weitere interessante Verbindungen der Formel I sind solche, worin
R₁, R₂, R₃ und R₄ für einen Rest 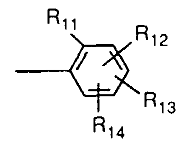 stehen, worin
R₁₁ C₁-C₄-Alkyl, C₁-C₄-Alkoxy, C₁-C₄-Alkylthio oder Halogen ist,
R₁₂, R₁₃ und R₁₄ unabhängig voneinander Wasserstoff, C₁-C₄-Alkyl, C₁-C₄-Alkoxy, C₁-C₄-Alkylthio oder Halogen sind
oder R₁, R₂, R₃ und R₄ für unsubstituiertes oder ein- bis vierfach mit C₁-C₄-Alkyl, C₁-C₄-Alkoxy, C₁-C₂-Alkylthio und/oder Halogen substituiertes Naphthyl, unsubstituiertes oder ein- bis vierfach mit C₁-C₄-Alkyl, C₁-C₄-Alkoxy, C₁-C₂-Alkylthio und/oder Halogen substituiertes Biphenyl stehen,
X für lineares oder verzweigtes C₁-C₁₂-Alkylen, ein- oder mehrmals durch -O- oder -S- unterbrochenes C₄-C₁₈-Alkylen oder mit Cl, F, Methoxy, Phenyl oder Benzyl substituiertes C₁-C₄-Alkulen steht, oder X C₂-C₈-Alkylen, welches mit einer oder zwei Gruppen der Formel G substituiert ist, bedeutet, oder X für eine Gruppe 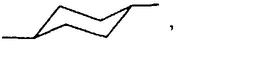 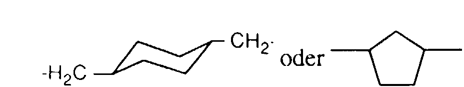 oder für eine Gruppe der Formel (IX'), (X') oder (XI') 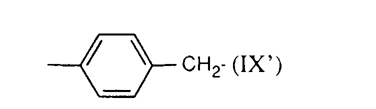 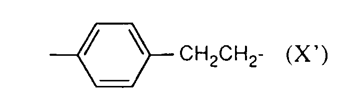 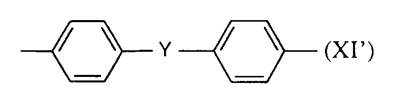 steht, oder X eine Gruppe -CH₂-CH=CH-CH₂- bedeutet, oder X für unsubstituiertes oder ein- bis dreifach mit Cl, F, C₁-C₄-Alkyl und/oder C₁-C₄-Alkoxy substituiertes Phenylen oder Xylylen steht, oder X mit ein bis zwei Gruppen G substituiertes Phenylen ist, oder X eine Gruppe der Formel (XIV) darstellt,
Y eine Einfachbindung, -CR₈R₉-, -O-, -S- oder -CH₂CH₂- ist und
R₈ und R₉ unabhängig voneinander Wasserstoff oder Methyl sind.

Hervorzuheben sind Verbindungen der Formel I, worin
R₁, R₂, R₃ und R₄ für einen Rest 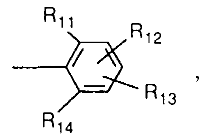 worin
R₁₁ und R₁₄ unabhängig voneinander C₁-C₄-Alkyl, C₁-C₄-Alkoxy, C₁-C₂-Alkylthio oder Halogen sind,
R₁₂ und R₁₃ unabhängig voneinander Wasserstoff, C₁-C₄-Alkyl, C₁-C₄-Alkoxy, C₁-C₂-Alkylthio oder Halogen sind,
X für lineares oder verzweigtes C₁-C₁₂-Alkylen, ein- oder mehrmals durch -O- oder -S- unterbrochenes C₄-C₁₄-Alkylen, C₂-C₈-Alkylen, welches mit einer oder zwei Gruppen der Formel G substituiert ist, eine Gruppe 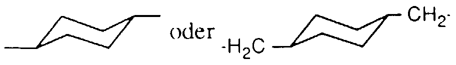 oder eine Gruppe der Formel (XI') steht, oder X eine Gruppe -CH₂-CH=CH-CH₂- , Phenylen oder Xylylen oder mit ein bis zwei Gruppen G substituiertes Phenylen ist, oder X eine Gruppe der Formel (XIV) darstellt,
Y eine Einfachbindung oder -CR₈R₉- ist und
R₈ und R₉ unabhängig voneinander Wasserstoff oder Methyl sind.

Ausserdem sind solche Verbindungen der Formel I bevorzugt, worin
R₁, R₂, R₃ und R₄ eine Gruppe der Formel 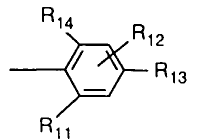 darstellen, worin
R₁₁ und R₁₄ unabhängig voneinander C₁-C₄-Alkyl, insbesondere Methyl, Methoxy oder Chlor bedeuten,
R₁₂ und R₁₃ unabhängig voneinander für C₁-C₄-Alkyl, insbesondere Methyl, C₁-C₄-Alkoxy, Chlor oder Wasserstoff stehen,
X für lineares oder verzweigtes C₁-C₁₂-Alkylen, ein- oder mehrmals durch -O- unterbrochenes C₄-C₁₈-Alkylen, C₃-C₆-Alkylen, welches mit einer oder zwei Gruppen der Formel G substituiert ist steht, oder X eine Gruppe -CH₂-CH=CH-CH₂- oder unsubstituiertes oder mit einer oder zwei Gruppen der Formel G substituiertes Phenylen ist, oder X eine Gruppe 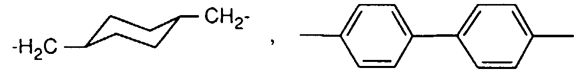 oder 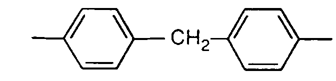 darstellt.

Insbesondere sind solche Verbindungen der Formel I bevorzugt, worin
R₁, R₂, R₃ und R₄ eine Gruppe der Formel 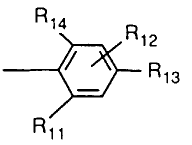 darstellen, worin
R₁₁ und R₁₄ unabhängig voneinander Methyl, Methoxy oder Chlor bedeuten,
R₁₂ und R₁₃ unabhängig voneinander für Methyl oder Wasserstoff stehen,
X für lineares oder verzweigtes C₁-C₁₂-Alkylen, ein- oder mehrmals durch -O- unterbrochenes C₄-C₁₈-Alkylen, C₃-C₆-Alkylen, welches mit einer oder zwei Gruppen der Formel G substituiert ist, steht, oder X eine Gruppe -CH₂-CH=CH-CH₂- oder unsubstituiertes oder mit einer oder zwei Gruppen der Formel G substituiertes Phenylen ist, oder X eine Gruppe 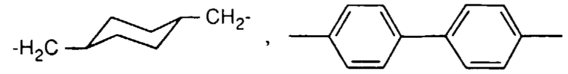 oder 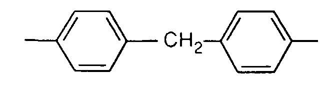 darstellt.

Interessante Verbindungen der Formel I sind solche, worin R₁₂ Wasserstoff ist, und X lineares oder verzweigtes C₁-C₁₂-Alkylen, ein- oder mehrmals durch -O- unterbrochenes C₄-C₁₈-Alkylen, C₃-C₆-Alkylen, welches mit einer oder zwei Gruppen der Formel G substituiert ist, bedeutet, oder X eine Gruppe -CH₂-CH=CH-CH₂-, Phenylen oder Xylylen ist, oder X eine Gruppe 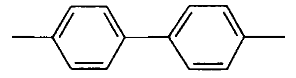 oder 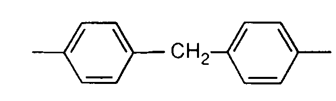 darstellt.

Ausserdem bevorzugt sind die Verbindungen der Formel I, worin X für lineares oder verzweigtes C₁-C₁₂-Alkylen, ein- oder mehrmals durch -O- unterbrochenes C₄-C₁₈-Alkylen steht, oder X eine Gruppe -CH₂-CH=CH-CH₂-, Phenylen, Xylylen oder 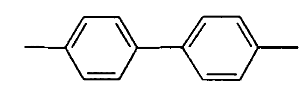 ist, oder X 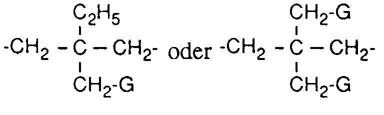 bedeutet.

Insbesondere interessant sind Verbindungen der Formel I, worin Z Sauerstoff bedeutet, n und m 1 sind, R₁, R₂, R₃ und R₄ gleich sind und zwei oder dreifach mit Methyl, Chlor oder Methoxy substituiertes Phenyl bedeuten und X C₄-C₁₂-Alkylen, 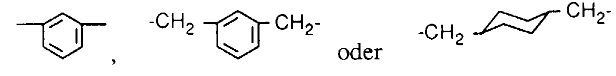 ist.

Besonders bevorzugt sind Verbindungen der Formel I, worin R₁, R₂, R₃ und R₄ gleich sind.

Weitere bevorzugte Verbindungen der Formel I sind solche, worin Z Sauerstoff bedeutet und n und m 1 sind.

Besonders interessant sind ausserdem Verbindungen der Formel I, worin n und m 1 sind.

Beispiele für erfindungsgemässe Verbindungen sind:
1,10-Bis[bis(2,6-dimethoxybenzoyl)phosphinoxid]decan,
1,10-Bis[bis(2,4,6-trimethylbenzoyl)phosphinoxid]decan,
1,6-Bis[bis(2,6-dimethoxybenzoyl)phosphinoxid]hexan,
1,2-Bis[bis(2,4,6-trimethylbenzoyl)phosphinoxid]ethan,
1,4-Bis[bis(2,6-dichlorobenzoyl)phosphinoxid]decan,
α,ω-Bis[bis(2,4,6-trimethylbenzoyl)phosphinoxid]-*p*-xylylen,
1[Bis(2,6-dimethoxybenzoyl)phosphinoxid]-8[bis(2,4,6-trimethylbenzoyl)phosphinoxid]-3,6-dioxa-octan,
1,1-Bis[bis(2,4,6-trimethylbenzoyl)phosphinoxid]1-undecyl-methan,
1,6-Bis[bis(2-methylnaphth-1-oyl)phosphinoxid]hexan,
1,4-Bis[bis(*t*-butanoyl)phosphinoxid]butan,
1,10-Bis[bis(2,4,6-trimethylbenzoyl)phosphinsulfid]decan.

Die erfindungsgemässen Verbindungen der Formel I können z.B. hergestellt werden durch doppelte Acylierung eines Phosphins (1) mit mindestens 4 Aequivalenten eines Säurechlorides (2) in Gegenwart von mindestens 4 Aequivalenten einer Base und anschliessender Oxidation des erhaltenen dimeren Phosphins (3) zum entsprechenden Phosphinoxid der Formel (I), oder durch Umsetzung des dimeren Phosphins (3) mit Schwefel zum entsprechenden Phosphinsulfid der Formel (I), nach dem Schema:

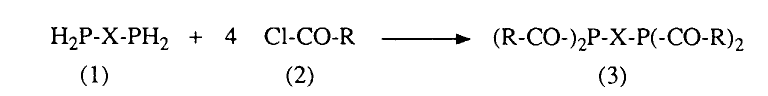

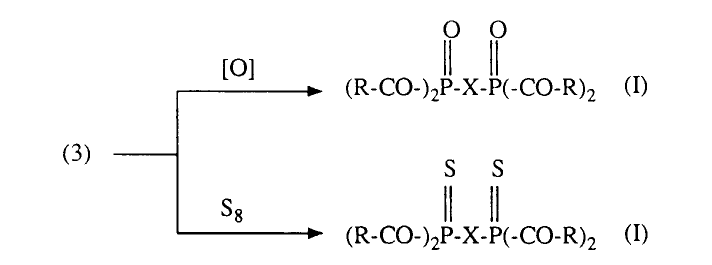

R hat die Bedeutungen von R₁, R₂, R₃ und R₄, wie oben definiert. X ist wie oben angegeben definiert.

Die unsymmetrischen Verbindungen der Formel (I) werden z.B. erhalten, wenn Gemische von Säurechloriden (2) mit unterschiedlichen R verwendet werden.

Als Base eignen sich z.B. tertiäre Amine, Pyridin, Alkalimetalle, Lithiumdiisopropylamid, Butyllithium, Erdalkalimetallcarbonate, Alkalialkoholate oder Alkalihydride. Die erste Reaktionsstufe geschieht vorzugsweise in Lösung. Als Lösemittel sind vor allem Kohlenwasserstoffe geeignet, wie z.B. Alkane und Alkangemische, Cyclohexan, Benzol, Toluol oder Xylol. Die Reaktion wird je nach Lösemittel und verwendeten Edukten bei unterschiedlichen Temperaturen durchgeführt. Bei der Verwendung von Basen, wie Lithiumdiisopropylamid oder Butyllithium, ist es z.B. zweckmässig bei -40-0 °C zu arbeiten. Die Reaktionen mit tert-Aminen, Alkalimetallen oder Alkalihydriden als Basen werden z.B. zweckmässig bei 10-120°C, vorzugsweise 20-80 °C, ausgeführt. Nach Abtrennen des gebildeten Basenchlorides kann das Phosphin (3) durch Eindampfen isoliert werden. Das rohe Reaktionsprodukt kann ohne Reinigung weitergeführt oder aber z.B. durch Destillation oder Kristallisation gereinigt werden. Die zweite Reaktionsstufe kann jedoch auch ohne Isolierung von (3) mit der Lösung des Rohproduktes durchgeführt werden.
Als Oxidationsmittel für die zweite Stufe zur Herstellung der Oxide eignen sich vor allem Wasserstoffperoxid und organische Peroxyverbindungen, beispielsweise Peressigsäure oder Luft.
Die Herstellung des Sulfids kann beispielsweise in Analogie zu der in der DE-A-3 034 697 beschriebenen Methode erfolgen. Die Reaktion wird zweckmässig in einer Inertgasatmosphäre aus z.B. Stickstoff, Argon oder Kohlendioxid, vorzugsweise Stickstoff, durchgeführt. Nach der Umsetzung kann es nötig sein, das entstandene Sulfid bzw. dessen Lösung durch Filtration von gegebenenfalls noch vorhandenem Schwefel abzutrennen.
Die Reaktionsprodukte können nach allgemein üblichen Methoden, wie z.B. durch Kristallisation oder Chromatographie gereinigt werden.

Die als Ausgangsmaterial benutzten primären Phosphine (1) sind bekannte, zum Teil kommerziell erhältliche Verbindungen oder können in Analogie zu bekannten Verbindungen hergestellt werden. Die Herstellung ist z.B. von G. Kosolapoff und L. Maier in Organic Phosphorous Compounds, Vol. 1, Wiley Interscience, 1972 beschrieben.

So können die Phosphine (1) z.B. durch Reaktion des Dibromids (4) mit einem Phosphorigsäureester (5) oder dem Natriumsalz eines Phosphonsäureesters (6) zum entsprechenden dimeren Ester (7), der durch Reduktion z.B. mit Lithiumaluminiumhydrid zum Phosphin (1) umgesetzt werden kann, hergestellt werden.

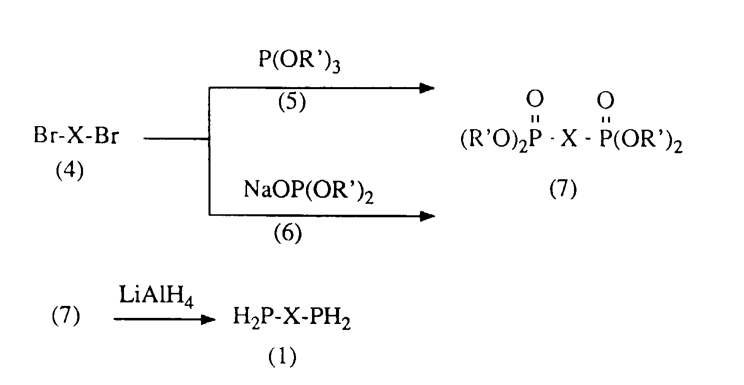

R' bedeutet z.B. C₁-C₄-Alkyl.
Die Reaktionen werden unter dem Fachmann allgemein bekannten Bedingungen durchgeführt. Solche Reaktionen sind beispielsweise in Inorg. Synth. 14 (1973), Seite 10 beschrieben. Die Hydrierung mit LiAlH₄ [(7)→ (1)] ist z.B. auch Helv. Chim. Acta 1966, Nr.96, Seite 842 zu entnehmen.

Die Herstellung der Säurechloride der Formel (2) erfolgt nach bekannten Methoden aus dem Stand der Technik.

Die erfindungsgemässen Verbindungen sind wenig flüchtige Photoinitiatoren mit guten Lösungseigenschaften in den zu polymerisierenden Substraten.

Erfindungsgemäss können die Verbindungen der Formel I als Photoinitiatoren für die Photopolymerisation von ethylenisch ungesättigten Verbindungen bzw. Gemischen, die solche Verbindungen enthalten, verwendet werden.
Diese Verwendung kann auch in Kombination mit einem anderen Photoinitiator und/oder anderen Additiven erfolgen.

Die Erfindung betrifft daher auch photopolymerisierbare Zusammensetzungen, enthaltend
(a) mindestens eine ethylenisch ungesättigte photopolymerisierbare Verbindung und
(b) als Photoinitiator mindestens eine Verbindung der Formel I
wobei die Zusammensetzung neben der Komponente (b) noch andere Photoinitiatoren und/oder andere Additive enthalten kann.

Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Interessant sind auch Silicon-acrylate. Weitere Beispiele sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol- oder Bisphenol-A-diacrylat, 4,4'-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanurat oder Tris-(2-acryloylethyl)isocyanurat.

Beispiele für höhermolekulare (oligomere) mehrfach ungesättigte Verbindungen sind acrylierte Epoxidharze, acrylierte oder Vinylether- oder Epoxy-Gruppen enthaltende Polyester, Polyurethane und Polyether. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Daneben können auch Vinylether-Monomere und -Oligomere, sowie maleat-terminierte Oligomere mit Polyester-, Polyurethan-, Polyether-, Polyvinylether- und Epoxidhauptketten eingesetzt werden. Insbesondere Kombinationen von Vinylethergruppen tragenden Oligomeren und Polymeren, wie sie in der WO 90/01512 beschrieben sind, sind gut geeignet. Aber auch Copolymere aus Vinylether und Maleinsäure funktionalisierten Monomeren kommen in Frage. Solche ungesättigten Oligomere kann man auch als Prepolymere bezeichnen.

Besonders geeignet sind z.B. Ester von ethylenisch ungesättigten Carbonsäuren und Polyolen oder Polyepoxiden, und Polymere mit ethylenisch ungesättigten Gruppen in der Kette oder in Seitengruppen, wie z. B. ungesättigte Polyester, Polyamide und Polyurethane und Copolymere hiervon, Polybutadien und Butadien-Copolymere, Polyisopren und Isopren-Copolymere, Polymere und Coplymere mit (Meth)Acrylgruppen in Seitenketten, sowie Mischungen von einem oder mehreren solcher Polymerer.

Beispiele für ungesättigte Carbonsäuren sind Acrylsäure, Methacrylsäure, Crotonsäure, Itaconsäure, Zimtsäure, ungesättigte Fettsäuren wie Linolensäure oder Oelsäure. Bevorzugt sind Acryl- und Methacrylsäure.

Als Polyole sind aromatische und besonders aliphatische und cycloaliphatische Polyole geeignet. Beispiele für aromatische Polyole sind Hydrochinon, 4,4'-Dihydroxydiphenyl, 2,2-Di(4-hydroxyphenyl)-propan, sowie Novolake und Resole. Beispiele für Polyepoxide sind solche auf der Basis der genannten Polyole, besonders der aromatischen Polyole und Epichlorhydrin. Ferner sind auch Polymere und Copolymere, die Hydroxylgruppen in der Polymerkette oder in Seitengruppen enthalten, wie z.B. Polyvinylalkohol und Copolymere davon oder Polymethacrylsäurehydroxyalkylester oder Copolymere davon, als Polyole geeignet. Weitere geeignete Polyole sind Oligoester mit Hydroxylendgruppen.

Beispiele für aliphatische und cycloaliphatische Polyole sind Alkylendiole mit bevorzugt 2 bis 12 C-Atomen, wie Ethylenglykol, 1,2- oder 1,3-Propandiol, 1,2-, 1,3- oder 1,4-Butandiol, Pentandiol, Hexandiol,Octandiol, Dodecandiol, Diethylenglykol, Triethylenglykol, Polyethylenglykole mit Molekulargewichten von bevorzugt 200 bis 1500, 1,3-Cyclopentandiol, 1,2-, 1,3- oder 1,4-Cyclohexandiol, 1,4-Dihydroxymethylcyclohexan, Glycerin, Tris-(β-hydroxyethyl)amin, Trimethylolethan, Trimethylolpropan, Pentaerythrit, Dipentaerythrit und Sorbit.

Die Polyole können teilweise oder vollständig mit einer oder verschiedenen ungesättigten Carbonsäuren verestert sein, wobei in Teilestern die freien Hydroxylgruppen modifiziert, z.B. verethert oder mit anderen Carbonsäuren verestert sein können.

Beispiele für Ester sind:
Trimethylolpropantriacrylat, Trimethylolethantriacrylat, Trimethylolpropantrimethacrylat, Trimethylolethantrimethacrylat, Tetramethylenglykoldimethacrylat, Triethylenglykoldimethacrylat, Tetraethylenglykoldiacrylat, Pentaerythritdiacrylat, Pentaerythrittriacrylat, Pentaerythrittetraacrylat, Dipentaerythritdiacrylat, Dipentaerythrittriacrylat, Dipentaerythrittetraacrylat, Dipentaerythritpentaacrylat, Dipentaerythrithexaacrylat, Tripentaerythritoctaacrylat, Pentaerythritdimethacrylat, Pentaerythrittrimethacrylat, Dipentaerythritdimethacrylat, Dipentaerythrittetramethacrylat, Tripentaerythritoctamethacrylat, Pentaerythritdiitaconat, Dipentaerythrittrisitaconat, Dipentaerythritpentaitaconat, Dipentaerythrithexaitaconat, Ethylenglykoldiacrylat, 1,3-Butandioldiacrylat, 1,3-Butandioldimethacrylat, 1,4-Butandioldiitaconat, Sorbittriacrylat, Sorbittetraacrylat, Pentaerythrit-modifiziert-triacrylat, Sorbittetramethacrylat, Sorbitpentaacrylat, Sorbithexaacrylat, Oligoesteracrylate und -methacrylate, Glycerindi- und -triacrylat, 1,4-Cyclohexandiacrylat, Bisacrylate und Bismethacrylate von Polyethylenglykol mit Molekulargewicht von 200 bis 1500, oder Gemische davon.

Als Komponente (a) sind auch die Amide gleicher oder verschiedener ungesättigter Carbonsäuren von aromatischen, cycloaliphatischen und aliphatischen Polyaminen mit bevorzugt 2 bis 6, besonders 2 bis 4 Aminogruppen geeignet. Beispiele für solche Polyamine sind Ethylendiamin, 1,2- oder 1,3-Propylendiamin, 1,2-, 1,3- oder 1,4-Butylendiamin, 1,5-Pentylendiamin, 1,6-Hexylendiamin, Octylendiamin, Dodecylendiamin, 1,4-Diaminocyclohexan, Isophorondiamin, Phenylendiamin, Bisphenylendiamin, Di-β-aminoethylether, Diethylentriamin, Triethylentetramin, Di-(β-aminoethoxy)- oder Di-(β-aminopropoxy)ethan. Weitere geeignete Polyamine sind Polymere und Copolymere mit gegebenenfalls zusätzlichen Aminogruppen in der Seitenkette und Oligoamide mit Aminoendgruppen. Beispiele für solche ungesättigten Amide sind: Methylen-bis-acrylamid, 1,6-Hexamethylen-bis-acrylamid, Diethylentriamin-tris-methacrylamid, Bis(methacrylamidopropoxy)-ethan, β-Methacrylamidoethylmethacrylat, N-[(β-Hydroxyethoxy)ethyl]-acrylamid.

Geeignete ungesättigte Polyester und Polyamide leiten sich z.B. von Maleinsäure und Diolen oder Diaminen ab. Die Maleinsäure kann teilweise durch andere Dicarbonsäuren ersetzt sein. Sie können zusammen mit ethylenisch ungesättigten Comonomeren, z.B. Styrol, eingesetzt werden. Die Polyester und Polyamide können sich auch von Dicarbonsäuren und ethylenisch ungesättigten Diolen oder Diaminen ableiten, besonders von längerkettigen mit z.B. 6 bis 20 C-Atomen. Beispiele für Polyurethane sind solche, die aus gesättigten oder ungesättigten Diisocyanaten und ungesättigten bzw. gesättigten Diolen aufgebaut sind.

Polybutadien und Polyisopren und Copolymere davon sind bekannt. Geeignete Comonomere sind z.B. Olefine wie Ethylen, Propen, Buten, Hexen, (Meth)-Acrylate, Acrylnitril, Styrol oder Vinylchlorid. Polymere mit (Meth)-Acrylatgruppen in der Seitenkette sind ebenfalls bekannt. Es kann sich z.B. um Umsetzungsprodukte von Epoxidharzen auf Novolakbasis mit (Meth)-Acrylsäure handeln, um Homo- oder Copolymere des Vinylalkohols oder deren Hydroxyalkylderivaten, die mit (Meth)-Acrylsäure verestert sind, oder um Homo- und Copolymere von (Meth)-Acrylaten, die mit Hydroxyalkyl(meth)acrylaten verestert sind.

Die photopolymerisierbaren Verbindungen können alleine oder in beliebigen Mischungen eingesetzt werden. Bevorzugt werden Gemische von Polyol(Meth)Acrylaten verwendet.

Den erfindungsgemässen Zusammensetzungen können auch Bindemittel zugesetzt werden, was besonders zweckmässig ist, wenn es sich bei den photopolymerisierbaren Verbindungen um flüssige oder viskose Substanzen handelt. Die Menge des Bindemittels kann z.B. 5-95, vorzugsweise 10-90 und besonders 40-90 Gew.-% betragen, bezogen auf den Gesamtfestkörper. Die Wahl des Bindemittels erfolgt je nach dem Anwendungsgebiet und hierfür geforderter Eigenschaften wie Entwickelbarkeit in wässrigen und organischen Lösungsmittelsystemen, Adhäsion auf Substraten und Sauerstoffempfindlichkeit.

Geeignete Bindemittel sind z.B. Polymere mit einem Molekulargewicht von etwa 5000-2 000 000, bevorzugt 10 000-1 000 000. Beispiele sind: Homo- und Copolymere Acrylate und Methacrylate, z.B. Copolymere aus Methylmethacrylat/Ethylacrylat/Methacrylsäure, Poly(methacrylsäurealkylester), Poly(acrylsäurealkylester); Celluloseester und -ether wie Celluloseacetat, Celluloseacetatbutyrat, Methylcellulose, Ethylcellulose; Polyvinylbutyral, Polyvinylformal, cyclisierter Kautschuk, Polyether wie Polyethylenoxid, Polypropylenoxid, Polytetrahydrofuran; Polystyrol, Polycarbonat, Polyurethan, chlorierte Polyolefine, Polyvinylchlorid, Copolymere aus Vinylchlorid/Vinylidenchlorid, Copolymere von Vinylidenchlorid mit Acrylnitril, Methylmethacrylat und Vinylacetat, Polyvinylacetat, Copoly(ethylen/vinylacetat), Polymere wie Polycaprolactam und Poly(hexamethylenadipamid), Polyester wie Poly(ethylenglykolterephtalat) und Poly(hexamethylenglykolsuccinat).

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösemitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon, Hydrochinonderivate, p-Methoxyphenol, β-Naphthol oder sterisch gehinderte Phenole wie z.B. 2,6-Di(tert-butyl)-p-kresol. Zur Erhöhung der Dunkellagerstabilität können z.B. Kupferverbindungen, wie Kupfernaphthenat, -stearat oder -octanoat, Phosphorverbindungen, wie z.B. Triphenylphosphin, Tributylphosphin, Triethylphosphit, Triphenylphosphit oder Tribenzylphosphit, quartäre Ammoniumverbindungen, wie z.B. Tetramethylammoniumchlorid oder Trimethyl-benzylammoniumchlorid, oder Hydroxylaminderivate, wie z.B. N-Diethylhydroxylamin verwendet werden. Zwecks Ausschluss des Luftsauerstoffes während der Polymerisation kann man Paraffin oder ähnliche wachsartige Stoffe zusetzen, die bei Beginn der Polymerisation wegen mangelnder Löslichkeit im Polymeren an die Oberfläche wandern und eine transparente Oberflächenschicht bilden, die den zutritt von Luft verhindert. Als Lichtschutzmittel können in geringer Menge UV-Absorber, wie z.B. solche vom Hydroxyphenyl-benztriazol-, Hydroxyphenyl-benzophenon-, Oxalsäureamid- oder Hydroxyphenyl-s-triazin-Typ, zugesetzt werden. Es können einzelne oder Mischungen dieser Verbindungen mit oder ohne Einsatz von sterisch gehinderten Aminen (HALS) verwendet werden.
Beispiele für solche UV-Absorber und Lichtschutzmittel sind
1. 2-(2'-Hydroxyphenyl)-benzotriazole, wie z.B. 2-(2'-Hydroxy-5'-methylphenyl)-benzotriazol, 2-(3',5'-Di-tert-butyl-2'-hydroxyphenyl)-benzotriazol, 2-(5'-tert-Butyl-2'-hydroxyphenyl)-benzotriazol, 2-(2'-Hydroxy-5'-(1,1,3,3-tetramethylbutyl)phenyl)-benzotriazol, 2-(3',5'-Di-tert-butyl-2'-hydroxyphenyl)-5-chlor-benzotriazol, 2-(3'-tert-Butyl- 2'-hydroxy-5'-methylphenyl)-5-chlor-benzotriazol, 2-(3'-sec-Butyl-5'-tert-butyl-2'-hydroxyphenyl)-benzotriazol, 2-(2'-Hydroxy-4'-octoxyphenyl)-benzotriazol, 2-(3',5'-Di-tert-amyl-2'-hydroxyphenyl)-benzotriazol, 2-(3',5'-Bis-(α,α-dimethylbenzyl)-2'-hydroxyphenyl)-benzotriazol, Mischung aus 2-(3'-tert-Butyl-2'-hydroxy-5'-(2-octyloxycarbonylethyl)-phenyl)-5-chlor-benzotriazol, 2-(3'-tert-Butyl-5'-[2-(2-ethylhexyloxy)-carbonylethyl]-2'-hydroxyphenyl)-5-chlor-benzotriazol, 2-(3'-tert-Butyl-2'-hydroxy-5'-(2-methoxycarbonylethyl)phenyl)-5-chlor-benzotriazol, 2-(3'-tert-Butyl-2'-hydroxy-5'-(2-methoxycarbonylethyl)phenyl)-benzotriazol, 2-(3'-tert-Butyl-2'-hydroxy-5'-(2-octyloxycarbonylethyl)phenyl)-benzotriazol, 2-(3'-tert-Butyl-5'-[2-(2-ethylhexyloxy)carbonylethyl]-2'-hydroxyphenyl)-benzotriazol, 2-(3'-Dodecyl-2'-hydroxy-5'-methylphenyl)-benzotriazol, und 2-(3'-tert-Butyl-2'-hydroxy-5'-(2-isooctyloxycarbonylethyl)phenyl-benzotriazol, 2,2'-Methylen-bis[4-(1,1,3,3-tetramethylbutyl)-6-benzotriazol-2-yl-phenol]; Umesterungsprodukt von 2-[3'-tert-Butyl-5'-(2-methoxycarbonylethyl)-2'-hydroxy-phenyl]-benzotriazol mit Polyethylenglycol 300; 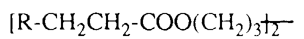 mit R = 3'-tert-Butyl-4'-hydroxy-5'-2H-benzotriazol-2-yl-phenyl.
2. 2-Hydroxybenzophenone, wie z.B. das 4-Hydroxy-, 4-Methoxy-, 4-Octoxy-, 4-Decyloxy-, 4-Dodecyloxy-, 4-Benzyloxy-, 4,2',4'-Trihydroxy-, 2'-Hydroxy-4,4'-dimethoxy-Derivat.
3. Ester von gegebenenfalls substituierten Benzoesäuren, wie z.B. 4-tert-Butyl-phenylsalicylat, Phenylsalicylat, Octylphenyl-salicylat, Dibenzoylresorcin, Bis-(4-tert-butylbenzoyl)-resorcin, Benzoylresorcin, 3,5-Di-tert-butyl-4-hydroxybenzoesäure-2,4-di-tert-butylphenylester, 3,5-Di-tert-butyl-4-hydroxybenzoesäurehexadecylester, 3,5-Di-tert-butyl-4-hydroxybenzoesäure-octadecylester, 3,5-Di-tert-butyl-4-hydroxybenzoesäure-2-methyl-4,6-di-tert-butylphenylester.
4. Acrylate, wie z.B. α-Cyan-β,β-diphenylacrylsäure-ethylester bzw. -isooctylester, α-Carbomethoxy-zimtsäuremethylester, α-Cyano-β-methyl-p-methoxy-zimtsäuremethylester bzw. -butylester, α-Carbomethoxy-p-methoxy-zimtsäure-methylester, N-(β-Carbomethoxy-β-cyanovinyl)-2-methyl-indolin.
5. Sterisch gehinderte Amine, wie z.B. Bis-(2,2,6,6-tetramethyl-piperidyl)-sebacat, Bis-(2,2,6,6-tetramethyl-piperidyl)-succinat, Bis-(1,2,2,6,6-pentamethylpiperidyl)-sebacat, n-Butyl-3,5-di-tert-butyl-4-hydroxybenzyl-malonsäure-bis(1,2, 2,6,6-pentamethylpiperidyl)-ester, Kondensationsprodukt aus 1-Hydroxyethyl-2,2,6,6-tetramethyl-4-hydroxypiperidin und Bernsteinsäure, Kondensationsprodukt aus N,N'-Bis-(2,2,6,6-Tetramethyl-4-piperidyl)-hexamethylendiamin und 4-tert-Octylamino-2,6-dichlor-1,3,5-s-triazin, Tris-(2,2,6,6-tetramethyl- 4-piperidyl)-nitrilotriacetat, Tetrakis-(2,2,6,6-tetramethyl-4-piperidyl)-1,2,3,4-butantetraoat, 1,1'-(1,2-Ethandiyl)-bis-(3,3,5,5-tetramethyl-piperazinon), 4-Benzoyl-2,2,6,6-tetramethylpiperidin, 4-Stearyloxy-2,2,6,6-tetramethylpiperidin, Bis-(1,2,2,6,6-pentamethylpiperidyl)-2-n-butyl-2-(2-hydroxy-3,5-di-tert-butylbenzyl)-malonat, 3-n-Octyl-7,7,9,9-tetramethyl-1,3,8-triazaspiro[4.5]decan-2,4-dion, Bis-(1-octyloxy-2,2,6,6-tetramethylpiperidyl)-sebacat, Bis-(1-octyloxy-2,2,6,6-tetramethylpiperidyl)-succinat, Kondensationsprodukt aus N,N'-Bis-(2,2,6,6-tetramethyl-4-piperidyl)-hexamethylendiamin und 4-Morpholino-2,6-dichlor-1,3,5-triazin, Kondensationsprodukt aus 2-Chlor-4,6-di-(4-n-butylamino-2,2,6,6-tetramethylpiperidyl)-1,3,5-triazin und 1,2-Bis-(3-aminopropylamino)äthan, Kondensationsprodukt aus 2-Chlor-4,6-di-(4-n-butylamino-1,2,2,6,6-pentamethylpiperidyl)-1,3,5-triazin und 1,2-Bis-(3-aminopropylamino)-äthan, 8-Acetyl-3-dodecyl-7,7,9,9-tetramethyl-1,3,8-triazaspiro[4.5]decan-2,4-dion, 3-Dodecyl-1-(2,2,6,6-tetramethyl-4-piperidyl)pyrrolidin-2,5-dion, 3-Dodecyl-1-(1,2,2,6,6-pentamethyl-4-piperidyl)-pyrrolidin-2,5-dion.
6. Oxalsäurediamide, wie z.B. 4,4'-Di-octyloxy-oxanilid, 2,2'-Diethoxy-oxanilid, 2,2'-Di-octyloxy-5,5'-di-tert-butyl-oxanilid, 2,2'-Di-dodecyloxy-5,5'di-tert-butyl-oxanilid, 2-Ethoxy-2'-ethyl-oxanilid, N,N'-Bis-(3-dimethylaminopropyl)-oxalamid, 2-Ethoxy-5-tert-butyl-2'-ethyloxanilid und dessen Gemisch mit 2-Ethoxy-2'-ethyl-5,4'-di-tert-butyl-oxanilid, Gemische von o- und p-Methoxy- sowie von o- und p-Ethoxy-di-substituierten Oxaniliden.
7. 2-(2-Hydroxyphenyl)-1,3,5-triazine, wie z.B. 2,4,6-Tris(2-hydroxy-4-octyloxyphenyl)-1,3,5-triazin, 2-(2-Hydroxy-4-octyloxyphenyl)-4,6-bis-(2,4-dimethylphenyl)-1,3,5-triazin, 2-(2,4-Dihydroxyphenyl)-4,6-bis(2,4-dimethylphenyl)-1,3,5-triazin, 2,4-Bis(2-hydroxy-4-propyloxyphenyl)-6-(2,4-dimethylphenyl)-1,3,5-triazin, 2-(2-Hydroxy-4-octyloxyphenyl)-4,6-bis(4-methylphenyl)-1,3,5-triazin, 2-(2-Hydroxy-4-dodecyloxyphenyl)-4,6-bis(2,4-dimethylphenyl)-1,3,5-triazin, 2-[2-hydroxy-4-(2-hydroxy-3-butyloxy-propyloxy)phenyl]-4,6-bis(2,4-dimethylphenyl)-1,3,5-triazin, 2-[2-hydroxy-4-(2-hydroxy-3-octyloxy-propyloxy)phenyl]-4,6-bis(2,4-dimethylphenyl)-1,3,5-triazin, 2-[4-dodecyl/tridecyl-oxy-(2-hydroxypropyl)oxy-2-hydroxyphenyl]-4,6-bis(2,4-dimethylphenyl)-1,3,5-triazin.
8. Phosphite und Phosphonite, wie z.B. Triphenylphosphit, Diphenylalkylphosphite, Phenyldialkylphosphite, Tris-(nonylphenyl)-phosphit, Trilaurylphosphit, Trioctadecylphosphit, Distearyl-pentaerythritdiphosphit, Tris-(2,4-di-tert-butylphenyl)-phosphit, Diisodecylpentaerythrit-diphosphit, Bis-(2,4-di-tert-butylphenyl)-pentaerythritdiphosphit, Bis-(2,6-di-tert-butyl-4-methylphenyl)-pentaerythritdiphosphit, Bis-isodecyloxy-pentaerythritdiphosphit, Bis-(2,4-di-tert-butyl-6-methylphenyl)-pentaerythritdiphosphit, Bis-(2,4,6-tri-tert-butylphenyl)-pentaerythritdiphosphit, Tristearyl-sorbit-triphosphit, Tetrakis-(2,4-di-tert-butylphenyl)-4,4'-biphenylen-diphosphonit, 6-Isooctyloxy-2,4,8,10-tetra-tert-butyl-12H-dibenz[d,g]-1,3,2-dioxaphosphocin, 6-Fluor-2,4,8,10-tetra-tert-butyl-12-methyl-di-benz[d,g]-1,3,2-dioxaphosphocin, Bis-(2,4-di-tert-butyl-6-methylphenyl)-methylphosphit, Bis-(2,4-di-tert-butyl-6-methylphenyl)-ethylphosphit.

Gegenstand der Erfindung sind auch Zusammensetzungen, worin als zusätzliches Additiv ein UV-Absorber aus der Klasse der Hydroxyphenyl-benztriazol-, Hydroxyphenyl-benzophenon-, Oxalsäureamid- oder Hydroxyphenyl-s-triazin-Verbindungen, gegebenenfalls in Gegenwart eines sterisch gehinderten Amins, zugesetzt wird. Solche erfindungsgemässen Zusammensetzungen werden bevorzugt zur Herstellung von UV-härtbaren Pulverlacken verwendet.

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Die Wirkung der Amine kann verstärkt werden durch den Zusatz von aromatischen Ketonen vom Typ des Benzophenons. Als Sauerstofffänger brauchbare Amine sind beispielsweise substituierte N,N-dialkylaniline, wie sie in der EP-A- 339 841 beschrieben sind.
Eine Beschleunigung der Photopolymerisation kann weiterhin durch Zusatz von Photosensibilisatoren geschehen, welche die spektrale Empfindlichkeit verschieben bzw. verbreitern. Dies sind insbesondere aromatische Carbonylverbindungen wie z.B. Benzophenon-, Thioxanthon-, Anthrachinon- und 3-Acylcumarinderivate sowie 3-(Aroylmethylen)-thiazoline, aber auch Eosin-, Rhodanin- und Erythrosin-Farbstoffe. Unterstützt werden kann der Härtungsvorgang insbesondere von, z.B. mit TiO₂, pigmentierten Zusammensetzungen, auch durch Zugabe einer unter thermischen Bedingungen radikalbildenden Komponente wie z.B. einer Azoverbindung wie etwa 2,2'-Azobis(4-methoxy-2,4-dimethylvaleronitril) oder einer Peroxyverbindung wie etwa Hydroperoxid oder Peroxycarbonat, z.B. t-Butylhydroperoxid, wie z.B. in der EP-A 245 639 beschrieben.

Die erfindungsgemässen Zusammensetzungen können auch einen photoreduzierbaren Farbstoff, wie z.B. Xanthen-, Benzoxanthen, Benzothioxanthen, Thiazin-, Pyronin, Porphyrin- oder Acridinfarbstoffe, und/oder eine durch Strahlung spaltbare Trihalogenmethylverbindung enthalten. Aehnliche Zusammensetzungen sind beispielsweise in der EP-A-445 624 beschrieben.

Weitere übliche Zusätze sind - je nach Verwendungszweck - optische Aufheller, Füllstoffe, Pigmente, Farbstoffe, Netzmittel oder Verlaufhilfsmittel. Zur Härtung dicker und pigmentierter Beschichtungen eignet sich der Zusatz von Mikro-Glaskugeln oder pulverisierter Glasfasern, wie z.B. im US-A-5 013 768 beschrieben.

Gegenstand der Erfindung sind auch Zusammensetzungen enthaltend als Komponente (a) mindestens eine in Wasser gelöste oder emulgierte ethylenisch ungesättigte photopolymerisierbare Verbindung.

Solche strahlungshärtbaren wässrigen Prepolymerdispersionen sind in vielen Variationen im Handel erhältlich. Man versteht darunter eine Dispersion aus Wasser und mindestens einem darin dispergierten Prepolymeren. Die Konzentration des Wassers in diesen Systemen liegt z.B. bei 5 bis 80, insbesondere 30 bis 60 Gew.-%. Das strahlungshärtbare Prepolymere bzw. Prepolymerengemisch ist beispielsweise in Konzentrationen von 95 bis 20, insbesondere 70 bis 40 Gew.-% enthalten. In diesen Zusammensetzungen ist die Summe der für Wasser und Prepolymere genannten Prozentzahlen jeweils 100, die Hilfs- und Zusatzstoffe kommen, je nach Verwendungszweck in unterschiedlichen Mengen hinzu.

Bei den strahlungshärtbaren, in Wasser dispergierten, oft auch gelösten filmbildenden Prepolymeren handelt es sich um für wässrige Prepolymerdispersionen an sich bekannte, durch freie Radikale initiierbare mono- oder polyfunktionelle ethylenisch ungesättigte Prepolymere, die beispielsweise einen Gehalt von 0,01 bis 1,0 Mol pro 100 g Prepolymer an polymerisierbaren Doppelbindungen, sowie ein mittleres Molekulargewicht von z.B. mindestens 400, insbesondere von 500 bis 10000 aufweisen. Je nach Anwendungszweck kommen jedoch auch Prepolymere mit höheren Molekulargewichten in Frage. Es werden beispielsweise polymerisierbare C-C-Doppelbindungen enthaltende Polyester mit einer Säurezahl von höchstens 10, polymerisierbare C-C-Doppelbindungen enthaltende Polyether, hydroxylgruppenhaltige Umsetzungsprodukte aus einem mindestens zwei Epoxidgruppen pro Molekül enthaltenden Polyepoxid mit mindestens einer α,β-ethylenisch ungesättigten Carbonsäure, Polyurethan(meth-)acrylate sowie α,β-ethylenisch ungesättigte Acrylreste enthaltende Acrylcopolymere verwendet, wie sie in der EP-A-12 339 beschrieben sind. Gemische dieser Prepolymeren können ebenfalls verwendet werden. In Frage kommen ausserdem die in der EP-A-33 896 beschriebenen polymerisierbaren Prepolymere, bei denen es sich um Thioetheraddukte von polymerisierbaren Prepolymeren mit einem mittleren Molekulargewicht von mindestens 600, einem Carboxylgruppengehalt von 0,2 bis 15 % und einem Gehalt von 0,01 bis 0,8 Mol polymerisierbarer C-C-Doppelbindungen pro 100 g Prepolymer handelt. Andere geeignete wässrige Dispersionen auf Basis von speziellen (Meth-)-Acrylsäurealkylester-Polymerisaten sind in der EP-A-41 125 beschrieben, geeignete in Wasser dispergierbare, strahlungshärtbare Prepolymere aus Urethanacrylaten sind der DE-A-29 36 039 zu entnehmen.
Als weitere Zusätze können diese strahlungshärtbaren wässrigen Prepolymerdispersionen Dispergierhilfsmittel, Emulgatoren, Antioxidantien, Lichtstabilisatoren, Farbstoffe, Pigmente, Füllstoffe, z.B. Talkum, Gips, Kieselsäure, Rutil, Russ, Zinkoxid, Eisenoxide, Reaktionsbeschleuniger, Verlaufsmittel, Gleitmittel, Netzmittel, Verdickungsmittel, Mattierungsmittel, Entschäumer und andere in der Lacktechnologie übliche Hilfsstoffe enthalten. Als Dispergierhilfsmittel kommen wasserlösliche hochmolekulare organische Verbindungen mit polaren Gruppen, wie z.B. Polyvinylalkohole, Polyvinylpyrrolidon oder Celluloseether in Frage. Als Emulgatoren können nicht-ionische, gegebenenfalls auch ionische Emulgatoren verwendet werden.

Die photopolymerisierbaren Zusammensetzungen enthalten den Photoinitiator (b) zweckmässig in einer Menge von 0,05 bis 15 Gew.-%, vorzugsweise 0,1 bis 5 Gew.-%, bezogen auf die Zusammensetzung.

In bestimmten Fällen kann es von Vorteil sein, Gemische von zwei oder mehr der erfindungsgemässen Photoinitiatoren zu verwenden. Selbstverständlich können auch Gemische mit bekannten Photoinitiatoren verwendet werden, z.B. Gemische mit Benzophenon, Acetophenonderivaten, wie beispielsweise α-Hydroxycycloalkylphenylketonen, Dialkoxyacetophenonen, α-Hydroxy- oder α-Aminoacetophenonen, 4-Aroyl-1,3-Dioxolanen, Benzoinalkylethern und Benzilketalen, Monoacylphosphinoxiden, Bisacylphosphinoxiden oder Titanocenen.
Im Falle des Einsatzes der erfindungsgemäßen Photoinitiatoren in Hybridsystemen werden zusätzlich zu den erfindungsgemäßen radikalischen Härtern kationische Photoinitiatoren wie z.B. aromatische Sulfonium- oder Iodonium-Salze oder Cyclopentadienyl-aren-eisen(II)-Komplexsalze verwendet.

Gegenstand der Erfindung sind auch Zusammensetzungen, worin die zusätzlichen Photoinitiatoren Verbindungen der Formel (XV) 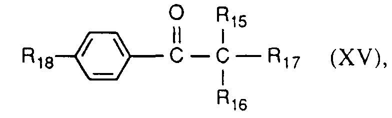 worin
R₁₈ für Wasserstoff, C₁-C₁₈-Alkyl, C₁-C₁₈-Alkoxy, -OCH₂CH₂-OR₁₉, eine Gruppe 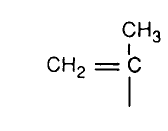 oder eine Gruppe 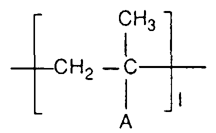 steht, worin
l einen Wert von 2 bis 10 hat und

A für den Rest 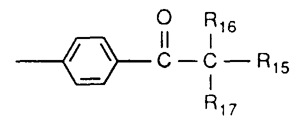 steht,
R₁₅ und R₁₆ unabhängig voneinander Wasserstoff, C₁-C₆-Alkyl, Phenyl, C₁-C₁₆-Alkoxy oder -O(CH₂CH₂O)_{q}-C₁-C₁₆-Alkyl, worin
q für eine Zahl von 1-20 steht, bedeuten,
oder R₁₅ und R₁₆ zusammen mit dem Kohlenstoffatom, an welches sie gebunden sind, einen Cyclohexylring bilden,
R₁₇ Hydroxy, C₁-C₁₆-Alkoxy oder -O(CH₂CH₂O)_{q}-C₁-C₁₆-Alkyl darstellt, wobei R₁₅, R₁₆ und R₁₇ nicht alle gleichzeitig C₁-C₁₆-Alkoxy oder -O(CH₂CH₂O)_{q}-C₁-C₁₆-Alkyl bedeuten, und
R₁₉ Wasserstoff, 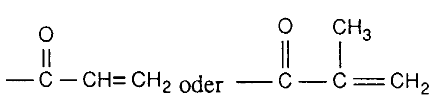 bedeutet, und/oder worin die zusätzlichen Photoinitiatoren Verbindungen der Formel (XVI) 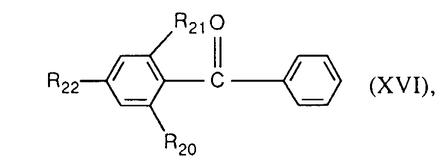 worin
R₂₀, R₂₁ und R₂₂ unabhängig voneinander Wasserstoff oder Methyl bedeuten, oder worin die zusätzlichen Photoinitiatoren Mischungen der Verbindungen der Formeln (XV) und/oder (XVI) sind.

R₁₈ als C₁-C₁₈-Alkyl, R₁₅ und R₁₆ als C₁-C₆-Alkyl und R₁₇ als C₁-C₄-Alkyl können die gleichen Bedeutungen haben wie für R₁ beschrieben, bis zur jeweiligen Anzahl der C-Atome.

R₁₈ als C₁-C₁₈-Alkoxy bedeutet beispielsweise verzweigtes oder unverzweigtes Alkoxy wie z.B. Methoxy, Ethoxy, n-Propyloxy, iso-Propyloxy, n-Butyloxy, iso-Butyloxy, sec-Butyloxy, tert-Butyloxy, Pentyloxy, Hexyloxy, Heptyloxy, Octyloxy, 2,4,4-Trimethyl-pent-1-yloxy, 2-Ethylhexyloxy, Nonyloxy, Decyloxy, Dodecyloxy oder Octadecyloxy.

R₁₅, R₁₆ und R₁₇ als C₁-C₁₆-Alkoxy können die gleichen Bedeutungen haben wie für R₁₈ beschrieben, bis zur entsprechenden Anzahl der C-Atome, vorzugsweise sind sie Decyloxy, Methoxy und Ethoxy, insbesondere Methoxy und Ethoxy.

Der Rest -O(CH₂CH₂O)_{q}-C₁-C₁₆-Alkyl steht für 1 bis 20 aufeinanderfolgende Ethylenoxid-Einheiten, deren Kette mit einem C₁-C₁₆-Alkyl beendet ist. Bevorzugt ist q 1 bis 10, z.B. 1 bis 8, insbesondere 1 bis 6. Vorzugsweise ist die Ethylenoxid-Einheiten-Kette mit einem C₁-C₁₀-, z.B. C₁-C₈-, insbesondere mit einem C₁-C₄-Alkyl terminiert.

Bevorzugt sind Zusammensetzungen, worin in der Formel (XV) R₁₅ und R₁₆ unabhängig voneinander C₁-C₆-Alkyl bedeuten, oder zusammen mit dem Kohlenstoffatom, an welches sie gebunden sind, einen Cyclohexylring bilden und R₁₇ für Hydroxy steht.

Weitere bevorzugte Zusammensetzungen sind solche, worin der Anteil an Verbindungen der Formel (I) im Gemisch mit Verbindungen der Formeln (XV) und/oder (XVI) 5 bis 95 %, bevorzugt 5 bis 50 %, beträgt.

Wichtig sind auch Zusammensetzungen worin in den Verbindungen der Formel (XV) R₁₅ und R₁₆ gleich sind und für Methyl stehen und R₁₇ Hydroxy oder i-Propoxy ist.

Ebenfalls bevorzugt sind Zusammensetzungen, enthaltend Verbindungen der Formel (I) und ein Gemisch von Verbindungen der Formel (XVI), in welchem Verbindungen der Formel (XVI) mit R₂₀ und R₂₂ gleich Wasserstoff und R₂₁ gleich Methyl zu 20 % und Verbindungen der Formel (XVI) mit R₂₀, R₂₁ und R₂₂ gleich Methyl zu 80 %, enthalten sind.

Interessant sind vor allen Dingen Zusammensetzungen wie oben beschrieben, welche Photoinitiatormischungen der Formeln (I), (XV) und/oder (XVI) enthalten, und bei Raumtemperatur flüssig sind.

Die Herstellung der Verbindungen der Formeln (XV) und (XVI) ist allgemein bekannt und ein Teil der Verbindungen ist im Handel erhältlich. Die Herstellung von oligomeren Verbindungen der Formel (XV) ist beispielsweise in der EP-A-0161 463 beschrieben. Eine Beschreibung der Herstellung von Verbindungen der Formel (XVI) ist z.B. der EP-A-209 831 zu entnehmen.

Die photopolymerisierbaren Zusammensetzungen können für verschiedene Zwecke verwendet werden, beispielsweise als Druckfarbe, als Klarlack, als Weisslack, z.B. für Holz oder Metall, als Anstrichstoff, u.a. für Papier, Holz, Metall oder Kunststoff, als Pulverlack, als tageslichthärtbarer Anstrich für Bauten- und Straßenmarkierung, für photographische Reproduktionsverfahren, für holographische Aufzeichnungsmaterialien, für Bildaufzeichnungsverfahren oder zur Herstellung von Druckplatten, die mit organischen Lösemitteln oder wässrig-alkalisch entwickelbar sind, zur Herstellung von Masken für den Siebdruck, als Zahnfüllmassen, als Klebstoffe, als drucksensitive Klebstoffe, als Laminierharze, als Aetz- oder Permanentresists und als Lötstoppmasken für elektronische Schaltungen, zur Herstellung von dreidimensionalen Gegenständen durch Massenhärtung (UV-Härtung in transparenten Formen) oder nach dem Stereolithographie-Verfahren, wie es z.B. im US-Patent Nr. 4,575,330 beschrieben ist, zur Herstellung von Verbundwerkstoffen (z.B. styrolischen Polyestern, die gegebenenfalls Glasfasern und andere Hilfsstoffe enthalten können) und anderen dickschichtigen Massen, zur Beschichtung oder Versiegelung von elektronischen Teilen oder als Ueberzüge für optische Fasern.
Die erfindungsgemäßen Verbindungen können weiterhin als Initatoren für Emulsionspolymerisationen, als Initiatoren einer Polymerisation für die Fixierung von Ordnungszuständen von flüssigkristallinen Mono- und Oligomeren, als Initiatoren für die Fixierung von Farbstoffen auf organischen Materialien, sowie zur Härtung von Pulverlacken verwendet werden.

In Lacken verwendet man häufig Gemische eines Prepolymeren mit mehrfach ungesättigten Monomeren, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwendet muss.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-OS 2 308 830 beschrieben sind.

Die erfindungsgemässen Verbindungen und Mischungen davon können weiterhin als radikalische Photoinitiatoren oder photoinitiierende Systeme für strahlenhärtbare Pulverlacke verwendet werden. Die Pulverlacke können auf festen Harzen und Monomeren enthaltend reaktive Doppelbindungen basieren, wie z.B. Maleaten, Vinylethern, Acrylaten, Acrylamiden und Mischungen davon. Ein radikalisch UV-härtbarer Pulverlack kann durch Mischen von ungesättigten Polyesterharzen mit festen Acrylamiden (z.B. Methacrylamido-glycolatmethylester) und einem erfindungsgemässen radikalischen Photoinitiator, wie beispielsweise im Vortrag "Radiation Curing of Powder Coatings", Conference Proceedings, Radtech Europe 1993 von M. Wittig und Th. Gohmann beschrieben, formuliert werden. Ebenso können radikalisch UV-härtbare Pulverlacke durch Mischen von ungesättigten Polyesterharzen mit festen Acrylaten, Methacrylaten oder Vinylethern und einem erfindungsgemässen Photoinitiator (bzw. Photoinitiatorgemisch) formuliert werden. Die UV-härtbaren Pulverlacke können auch weisse oder farbige Pigmente enthalten. So kann z.B. vorzugsweise Rutil-Titaniumdioxid bis zu Konzentrationen von 50 Gew.-% eingesetzt werden, um einen gehärteten Pulverlack mit gutem Abdeckungsvermögen zu erhalten. Das Verfahren beinhaltet normalerweise elektrostatisches oder tribostatisches Aufsprühen des Pulvers auf das Substrat, wie z.B. Metall oder Holz, Aufschmelzen des Pulvers durch Erwärmen und, nachdem ein glatter Film entstanden ist, Strahlenhärten des Überzugs mit ultraviolettem und/oder sichtbaren Licht, z.B. mit Quecksilbermitteldrucklampen, Metallhalogenidlampen oder Xenonlampen. Ein besonderer Vorteil der strahlenhärtbaren Pulverlacke im Vergleich zu den entsprechenden thermisch härtbaren liegt darin, dass die Fliesszeit nach dem Aufschmelzen der Pulverpartikel wahlweise hinausgezögert werden kann, um die Bildung eines glatten hochglänzenden Überzugs zu gewährleisten. Im Gegensatz zu thermisch härtbaren Systemen können strahlenhärtbare Pulverlacke ohne den unerwünschten Effekt der Lebensdauerverkürzung so formuliert werden, dass sie bei niedrigeren Temperaturen schmelzen. Aus diesem Grund sind sie auch geeignet als Überzüge für wärmeempfindliche Substrate, wie z.B. Holz oder Kunststoffe.
Die Pulverlackformulierungen können neben den erfindungsgemässen Photoinitiatoren auch UV-Absorber enthalten. Entsprechende Beispiele sind vorstehend unter den Punkten 1.-8. aufgeführt.

Die erfindungsgemässen photohärtbaren Zusammensetzungen eignen sich z.B. als Beschichtungsstoffe für Substrate aller Art, z.B. Holz, Textilien, Papier, Keramik, Glas, Kunststoffe wie Polyester, Polyethylenterephthalat, Polyolefine oder Celluloseacetat, insbesondere in Form von Filmen, sowie Metalle wie Al, Cu, Ni, Fe, Zn, Mg oder Co und GaAs, Si oder SiO₂, auf denen eine Schutzschicht oder durch bildmässiges Belichten eine Abbildung aufgebracht werden soll.

Die Beschichtung der Substrate kann erfolgen, indem man eine flüssige Zusammensetzung, eine Lösung oder Suspension auf das Substrat aufbringt. Die Wahl des Lösungsmittels und die Konzentration richten sich hauptsächlich nach der Art der Zusammensetzung und nach dem Beschichtungsverfahren. Das Lösungsmittel soll inert sein, d.h. es soll mit den Komponenten keine chemische Reaktion eingehen und es soll bei der Trocknung nach dem Beschichten wieder entfernt werden können. Geeignete Lösungsmittel sind z.B. Ketone, Ether und Ester, wie Methylethylketon, Isobutylmethylketon, Cyclopentanon, Cyclohexanon, N-Methylpyrrolidon, Dioxan, Tetrahydrofuran, 2-Methoxyethanol, 2-Ethoxyethanol, 1-Methoxy-2-propanol, 1,2-Dimethoxyethan, Essigsäureethylester, Essigsäure-n-butylester und 3-Ethoxy-propionsäureethylester.
Die Lösung wird mittels bekannter Beschichtungsverfahren gleichförmig auf ein Substrat aufgebracht, z.B. durch Schleudern, Tauchen, Rakelbeschichtung, Vorhanggiessverfahren, Aufpinseln, Sprühen, speziell durch elektrostatisches Sprühen und Reverse-Roll-Beschichtung. Es ist auch möglich, die lichtempfindliche Schicht auf einen temporären, flexiblen Träger zu bringen und dann durch Schichtübertragung via Lamination das endgültige Substrat, z.B. eine kupferkaschierte Leiterplatte, zu beschichten.

Die Auftragsmenge (Schichtdicke) und Art des Substrates (Schichtträger) sind abhängig vom gewünschten Applikationsgebiet. Der Schichtdickenbereich umfasst im allgemeinen Werte von ca 0,1 µm bis mehr als 10 µm.

Die erfindungsgemässen strahlungsempfindlichen Zusammensetzungen finden Anwendung als Negativresists, die eine sehr hohe Lichtempfindlichkeit aufweisen und schwellungsfrei in wässrig-alkalischem Medium entwickelt werden können. Sie eignen sich als Photoresists für die Elektronik (Galvanoresist, Aetzresist, Lötstopresist), die Herstellung von Druckplatten, wie Offsetdruckplatten oder Siebdruckformen, den Einsatz beim Formteilätzen oder den Einsatz als Mikroresist bei der Herstellung integrierter Schaltkreise. Dementsprechend unterschiedlich sind die möglichen Schichträger und die Verarbeitungsbedingungen der beschichteten Substrate.

Für photographische Informationsaufzeichnungen dienen z.B. Folien aus Polyester, Celluloseacetat oder mit Kunststoff beschichtete Papiere; für Offsetdruckformen speziell behandeltes Aluminium, für die Herstellung gedruckter Schaltungen kupferkaschierte Laminate und für die Herstellung von integrierten Schaltkreisen Siliziumwafer. Die Schichtdicken für photographische Materialien und Offsetdruckformen betragen in der Regel ca. 0,5 µm bis 10 µm, für gedruckte Schaltungen 0,4 µm bis ca. 2 µm.

Nach dem Beschichten der Substrate wird das Lösungsmittel in der Regel durch Trocknen entfernt, und es resultiert eine Schicht des Photoresists auf dem Träger.

Der Begriff "bildmässige" Belichtung beinhaltet sowohl die Belichtung durch eine Photomaske, die ein vorbestimmtes Muster enthält, beispielsweise ein Diapositiv, die Belichtung durch einen Laserstrahl, der beispielsweise computergesteuert über die Oberfläche des beschichteteten Substrates bewegt wird und auf diese Weise ein Bild erzeugt, sowie die Bestrahlung mit computergesteuerten Elektronenstrahlen.

Nach der bildmässigen Belichtung des Materials und vor der Entwicklung kann es vorteilhaft sein, für kürzere Zeit ein thermische Behandlung durchzuführen. Dabei werden nur die belichteten Teile thermisch gehärtet. Die angewandten Temperaturen liegen im allgemeinen bei 50-150 °C, bevorzugt bei 80-130 °C; die Zeit für die thermische Behandlung liegt in der Regel zwischen 0,25 und 10 Minuten.

Die photohärtbare Zusammensetzung kann weiterhin in einem Verfahren zur Herstellung von Druckformen oder Photoresists wie es z.B. in der DE-A-4013358 beschrieben wird verwendet werden. Darin wird die Zusammensetzung vor, zugleich mit oder nach der bildmäßigen Bestrahlung kurzzeitig mit sichtbarem Licht einer Wellenlänge von mindestens 400 nm ohne Maske belichtet.

Nach der Belichtung und gegebenenfalls thermischen Behandlung werden die unbelichteten Stellen des Photolacks in an sich bekannter Weise mit einem Entwickler entfernt.

Die erfindungsgemässen Zusammensetzungen sind -wie schon erwähnt-wässrig-alkalisch entwickelbar. Geeignete wässrig-alkalische Entwickler-Lösungen sind insbesondere wässrige Lösungen von Tetraalkylammoniumhydroxiden oder von Alkalimetallsilikaten, -phosphaten, -hydroxiden und -carbonaten. Diesen Lösungen können gegebenenfalls noch kleinere Mengen an Netzmitteln und/oder organischen Lösungsmitteln zugesetzt sein. Typische organische Lösungsmittel, die den Entwicklerflüssigkeiten in kleinen Mengen zugesetzt werden können, sind beispielsweise Cyclohexanon, 2-Ethoxyethanol, Toluol, Aceton sowie Mischungen solcher Lösungsmittel.

Grosse Bedeutung hat die Photohärtung für Druckfarben, da die Trocknungszeit des Bindemittels ein massgeblicher Faktor für die Produktionsgeschwindigkeit graphischer Erzeugnisse ist und in der Grössenordnung von Bruchteilen von Sekunden liegen soll. Insbesondere für den Siebdruck sind UV-härtbare Farben von Bedeutung.

Gut geeignet sind die erfindungsgemässen Gemische -wie oben bereits erwähnt- auch zur Herstellung von Druckplatten. Hierbei werden z. B. Gemische von löslichen linearen Polyamiden oder Styrol/Butadien bzw. Styrol/Isopren Kautschuk, Polyacrylaten oder Polymethylmethacrylaten mit Carboxyl-Gruppen, Polyvinylalkoholen oder Urethanacrylaten mit photopolymerisierbaren Monomeren, beispielsweise Acryl- bzw. Methacrylamiden oder Acryl- bzw. Methacrylestern, und einem Photoinitiator verwendet. Filme und Platten aus diesen Systemen (nass oder trocken) werden über das Negativ (oder Positiv) der Druckvorlage belichtet und die ungehärteten Teile anschliessend mit einem geeigneten Lösemittel eluiert.

Ein weiteres Einsatzgebiet der Photohärtung ist die Metallbeschichtung, beispielsweise bei der Lackierung von Blechen und Tuben, Dosen oder Flaschenverschlüssen, sowie die Photohärtung auf Kunststoffbeschichtungen, beispielsweise von Fussboden- oder Wandbelägen auf PVC-Basis.

Beispiele für die Photohärtung von Papierbeschichtungen sind die farblose Lackierung von Etiketten, Schallplattenhüllen oder Buchumschlägen.

Ebenfalls interessant ist die Verwendung der erfindungsgemässen Verbindungen zur Härtung von Formteilen aus Verbundmassen. Die Verbundmasse besteht aus einem selbsttragenden Matrixmaterial, z.B. einem Glasfasergewebe, das mit der lichthärtenden Formulierung durchtränkt wird. Mit den erfindungsgemässen Verbindungen hergestellte Formteile aus Verbundmassen erreichen eine hohe mechanische Stabilität und Widerstandsfähigkeit. Die erfindungsgemässen Verbindungen sind auch als Photohärter in Form-, Tränk- und Überzugsmassen, wie sie beispielsweise in der EP-A-7086 beschrieben sind, einsetzbar. Solche Massen sind beispielsweise Feinschichtharze, an die hohe Anforderungen bezüglich der Härtungsaktivität und Vergilbungsresistenz gestellt werden, faserverstärkte Formstoffe, wie z.B. plane, längs- oder quergewellte Lichtplatten. Verfahren zur Herstellung von solchen Formstoffen, wie z.B. Handauflegeverfahren, Faserspritz-, Schleuder- oder Wickelverfahren, sind z.B. von P.H. Selden in "Glasfaserverstärkte Kunststoffe", Seite 610, Springer Verlag Berlin-Heidelberg-New York 1967, beschrieben. Gebrauchsgegenstände, die beispielsweise nach diesem Verfahren hergestellt werden können sind Boote, beidseitig mit glasfaserverstärktem Kunststoff beschichtete Span- oder Tischlerplatten, Rohre, Behälter usw. Weitere Beispiele für Form-, Tränk- und Überzugsmassen sind UP-Harz-Feinschichten für glasfaserhaltige Formstoffe (GFK), z.B. Wellplatten und Papierlaminate. Papierlaminate können auch auf Harnstoff- oder Melaminharzen basieren. Die Feinschicht wird vor der Laminatherstellung auf einem Träger (z.B. einer Folie) erzeugt. Die erfindungsgemässen photohärtbaren Zusammensetzungen können auch für Giessharze oder zur Einbettung von Gegenständen, z.B. von Elektronikteilen usw., verwendet werden. Zur Härtung werden Quecksilbermitteldrucklampen verwendet, wie sie in der UV-Härtung üblich sind. Von besonderem Interesse sind aber auch weniger intensive Lampen, z.B. vom Typ TL 40W/03 oder TL40W/05. Die Intensität dieser Lampen entspricht etwa dem Sonnenlicht. Es kann auch direktes Sonnenlicht zur Härtung eingesetzt werden. Ein weiterer Vorteil ist, dass die Verbundmasse in einem angehärteten, plastischen Zustand von der Lichtquelle entfernt und verformt werden kann. Danach erfolgt die vollständige Aushärtung.

Wichtig ist auch die Verwendung von photohärtbaren Zusammensetzungen für Abbildungsverfahren und zur optischen Herstellung von Informationsträgern. Hierbei wird -wie oben bereits beschrieben- die auf dem Träger aufgebrachte Schicht (nass oder trocken) durch eine Photomaske mit UV oder sichtbarem Licht bestrahlt und die unbelichteten Stellen der Schicht durch Behandlung mit einem Lösemittel (=Entwickler) entfernt. Das Aufbringen der photohärtbaren Schicht kann auch im Elektroabscheidungsverfahren auf Metall geschehen. Die belichteten Stellen sind vernetzt-polymer und dadurch unlöslich und bleiben auf dem Träger stehen. Bei entsprechender Anfärbung entstehen sichtbare Bilder. Ist der Träger eine metallisierte Schicht, so kann das Metall nach dem Belichten und Entwickeln an den unbelichteten Stellen weggeätzt oder durch Galvanisieren verstärkt werden. Auf diese Weise lassen sich gedruckte elektronische Schaltungen und Photoresists herstellen.

Die Lichtempfindlichkeit der erfindungsgemässen Zusammensetzungen reicht in der Regel vom UV-Gebiet (ca.200 nm) bis ca. 600 nm und umspannt somit einen sehr breiten Bereich. Geeignete Strahlung enthält z.B. Sonnenlicht oder Licht, aus künstlichen Lichtquellen. Als Lichtquellen kommen daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilbermitteldruck-, -hochdruck- und -niederdruckstrahler, gegebenenfalls mit Metall-Halogeniden dotiert (Metall-Halogenlampen), mikrowellenangeregte Metalldampflampen, Excimer Lampen, superaktinische Leuchtstoffröhren, Fluoreszenzlampen, Argonglühlampen, Elektronenblitzlampen, photographische Flutlichtlampen, Elektronenstrahlen und Röntgenstrahlen, erzeugt mittels Synchrotronen oder Laser-Plasma. Der Abstand zwischen Lampe und erfindungsgemässem zu belichtendem Substrat kann je nach Anwendungszweck und Lampentyp bzw. -stärke variieren, z.B. zwischen 2 cm bis 150 cm. Speziell geeignet sind Laserlichtquellen, z.B. Excimer-Laser, wie Krypton-F-Laser zur Belichtung bei 248 nm. Auch Laser im sichtbaren Bereich können eingesetzt werden. Hier ist die hohe Empfindlichkeit der erfindungsgemässen Materialien sehr vorteilhaft. Nach dieser Methode können gedruckte Schaltungen in der Elektronikindustrie, lithographische Offsetdruckplatten oder Reliefdruckplatten sowie photographische Bildaufzeichnungsmaterialien hergestellt werden.

Unter Tageslicht bzw. tageslichtäquivalenten Lichtquellen ist Strahlung der Wellenlänge 300-500 nm zu verstehen. Zur Härtung muss dabei insbesondere Strahlung der Wellenlänge 350-450 nm vorhanden sein. Im Gegensatz zur üblichen UV-Härtung mit Strahlung hoher Intensität wird bei der Härtung mit Tageslicht die Härtung durch Einwirkung von Strahlung geringerer Intensität über einen längeren Zeitraum erreicht. Solche Strahlung ist beispielsweise Sonnenlicht, sowie dem Tageslicht äquivalente Strahlungsquellen. Sonnenlicht unterscheidet sich von dem Licht der üblicherweise in der UV-Härtung gebräuchlichen künstlichen Strahlungsquellen hinsichtlich seiner spektralen Zusammensetzung und der Intensität. Die Absorptionscharakteristika und die Radikalbildungseigenschaften der im erfindungsgemässen Verfahren eingesetzten Bisacylphosphinoxide sind in besonderer Weise geeignet, das Sonnenlicht als natürliche Strahlungsquelle für die Härtung auszunutzen.
Die im erfindungsgemässen Verfahren eingesetzten dimeren Bisacylphosphinoxide ergeben innerhalb von 1-120, z.B. 1-60, 1-30, insbesondere 1-15 Minuten klebfreie Oberflächen bei der Bestrahlung mit Tageslicht bzw. tageslichtäquivalenten Lichtquellen. Die Strahlungsintensitäten der für die Härtung nutzbaren Strahlung liegen im Bereich von 10-30, vorzugsweise 10-20 mW/cm². Die Intensitäten der künstlichen Strahler, die üblicherweise in der UV-Härtung eingesetzt werden, sind dagegen im UV-Bereich grösser als 50 mW/cm². Unter tageslichtäquivalenten künstlichen Lichtquellen, wie sie im erfindungsgemässen Verfahren verwendet werden können, sind Strahler geringer Intensität wie etwa bestimmte Leuchtstofflampen, z.B. die TL05 Philips Spezial-Leuchtstofflampe oder die TL09 Philips Spezial-Leuchtstofflampe, zu verstehen.

Gegenstand der Erfindung ist daher auch die Verwendung von Verbindungen der Formel I, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind zur Härtung von ethylenisch ungesättigten Verbindungen mit Tageslicht bzw. tageslichtäquivalenten Lichtquellen, sowie ein Verfahren zur Härtung von ethylenisch ungesättigten polymerisierbaren Verbindungen dadurch gekennzeichnet, dass man diesen mindestens einen Photoinitiator der Formel I, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind, zusetzt und mit Tageslicht bzw. tageslichtäquivalenten Lichtquellen bestrahlt.

Bevorzugt sind für diese Verwendung, bzw. dieses Verfahren Verbindungen der Formel I, worin Z Sauerstoff ist, R₁₁ und R₁₄ Methyl bedeuten und R₁₂ und R₁₃ für Wasserstoff oder Methyl stehen.

Gegenstand der Erfindung ist ebenfalls die Verwendung von Verbindungen der Formel I, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind, zur Härtung von Formteilen aus Verbundmassen, sowie ein Verfahren zur Härtung von Formteilen aus Verbundmassen mit den oben definierten Verbindungen der Formel I.

Erfindungsgegenstand ist auch die Verwendung der erfindungsgemässen Zusammensetzung zur Herstellung von Anstrichstoffen, insbesondere Weisslacken für Holz- und Metallanstriche oder Klarlacken, zur Herstellung von buntpigmentierten Lacken, zur Herstellung von klaren oder pigmentierten wässrigen Dispersionen, zur Herstellung von Druckfarben, zur Herstellung von Pulverlacken, zur Herstellung von dreidimensionalen Gegenständen durch Massenhärtung oder Stereolithographie, zur Herstellung von Zahnfüllmassen, zur Herstellung von Druckplatten, zur Herstellung von Masken für den Siebdruck, zur Herstellung von Photoresists für gedruckte elektronische Schaltungen, zur Herstellung von Klebstoffen, als Ueberzug für optische Fasern oder als Beschichtung oder Versiegelung von elektronischen Bauteilen.

Gegenstand der Erfindung ist auch ein Verfahren zur Photopolymerisation von Verbindungen mit ethylenisch ungesättigten Doppelbindungen, dadurch gekennzeichnet, dass man eine wie oben beschriebene Zusammensetzung mit Licht im Bereich von 200 bis 600 nm bestrahlt.

Erfindungsgemäss wird dieses Verfahren auch zur Herstellung von Anstrichstoffen, insbesondere Weisslacken für Holz- und Metallanstriche oder Klarlacken, zur Herstellung von buntpigmentierten Lacken, zur Herstellung von klaren oder pigmentierten wässrigen Dispersionen, zur Herstellung von Druckfarben, zur Herstellung von Pulverlacken, zur Herstellung von Anstrichstoffen für tageslichthärtbare Bautenanstriche und Strassenmarkierungen, zur Herstellung von Zahnfüllmassen, zur Herstellung von Druckplatten, zur Herstellung von Masken für den Siebdruck, zur Herstellung von Photoresists für gedruckte elektronische Schaltungen, zur Herstellung von Klebstoffen, zur Herstellung von Ueberzugen für optische Fasern, zur Herstellung von Beschichtungen oder Versiegelungen von elektronischen Bauteilen, sowie zur Methode der Massenhärtung oder Stereolithographie, verwendet.

Ebenfalls Gegenstand der Erfindung ist ein beschichtetes Substrat, das auf mindestens einer Oberfläche mit einer wie oben beschriebenen Zusammensetzung beschichtet ist, sowie ein Verfahren zur photographischen Herstellung von Reliefabbildungen, in welchem ein beschichtetes Substrat bildmässig belichtet wird und danach die unbelichteten Anteile mit einem Lösemittel entfernt werden.

Die nachfolgenden Beispiele erläutern die Erfindung weiter. Angaben in Teilen oder Prozenten beziehen sich, ebenso wie in der übrigen Beschreibung und in den Patentansprüchen, auf das Gewicht, sofern nichts anderes angegeben ist.

### Beispiel 1 (Methode A):

### Herstellung von 1,10-Bis[bis(2,4,6-trimethylbenzoyl)phosphinoxid]-decan

Zu einer Lösung von 25,3 g (0,25 mol) Diisopropylamin in 100 ml Tetrahydrofuran (THF) werden unter Stickstoffatmosphäre bei 0 °C 156,4 ml (0,25 mol) 1,6M Butyllithium innerhalb von 30 Minuten getropft. Bei -20 bis -30 °C wird diese Lösung zu einer Lösung von 45,7 g (0,25 mol) 2,4,6-Trimethylbenzoylchlorid und 12,9 g (0,0625 mol) 1,10-Bis-(phosphino)decan in 200 ml THF getropft. Nach 2 Stunden Rühren bei -30 °C wird die gelbe Lösung auf Raumtemperatur erwärmen lassen und einmal mit Wasser gewaschen. Die organische Phase wird mit Magnesiumsulfat getrocknet, filtriert und am Rotationsverdampfer eingeengt. Der Rückstand wird in 200 ml Toluol gelöst und mit 14,2 g (0,125 mol) 30%igem Wasserstoffperoxid versetzt. Nach 2 Stunden Rühren bei 50 °C wird die Reaktionsmischung mit Wasser und gesättigter Natriumhydrogencarbonat-Lösung nachgewaschen, mit Magnesiumsulfat getrocknet, filtriert und am Rotationsverdampfer eingeengt. Nach Reinigung mittels Chromatographie (Laufmittel: Hexan/Essigsäureethylester 3:1) und anschliessender Umkristallisation aus Hexan werden 16,1 g (31,3 % d.Theorie) der Titelverbindung als gelbes Pulver mit einem Schmelzpunkt von 94-95 °C erhalten.

| Elementaranalyse: | | | | | |
|---|---|---|---|---|---|
| ber.: | C: | 73,15 % | gef.: | C: | 73,03 % |
| | H: | 7,61 % | | H: | 7,68 % |

### Beispiel 2 (Methode B):

### Herstellung von 1,6-Bis[bis(2,6-dimethoxybenzoyl)phosphinoxid]-hexan

Zu einer Lösung aus 36,0 g (0,18 mol) 2,6-Dimethoxybenzoylchlorid in 400 ml Toluol wird bei 90-100 °C ein Gemisch aus 6,8 g (0,045 mol, 50%ig in Toluol) 1,6-Bis(phosphino)hexan und 18,2 g (0,18 mol) Triethylamin getropft. Nach 6 Stunden Rühren bei 90-100 °C wird die gebildete Suspension auf Raumtemperatur abkühlen lassen, mit Toluol verdünnt, einmal mit Wasser und einmal mit Natriumbicarbonat-Lösung gewaschen. Die organische Phase wird mit 10,2 g (0,09 mol) 30%igem Wasserstoffperoxid versetzt und 2 Stunden bei 60 °C gerührt. Danach wird mit Wasser und gesättigter Natriumbicarbonat-Lösung gewaschen, mit Magnesiumsulfat getrocknet, filtriert und am Rotationsverdampfer eingeengt. Nach der Kristallisation aus Essigsäureethylester werden 10,9 g (28,9 % d. Theorie) der Titelverbindung als gelbes Pulver mit einem Schmelzpunkt von 219-220 °C erhalten.

| Elementaranalyse: | | | | | |
|---|---|---|---|---|---|
| ber.: | C: | 60,14 % | gef.: | C: | 59,37 % |
| | H: | 5,77% | | H: | 5,83 % |

### Beispiele 3-7:

Die Verbindungen der Beispiele 3-7 werden gemäss den oben beschriebenen Methoden A oder B hergestellt.

Die Verbindungen, die jeweilige Herstellungsmethode und physikalische Daten sind in der folgenden Tabelle 1 wiedergegeben.

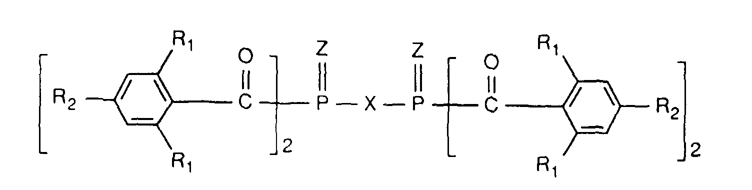

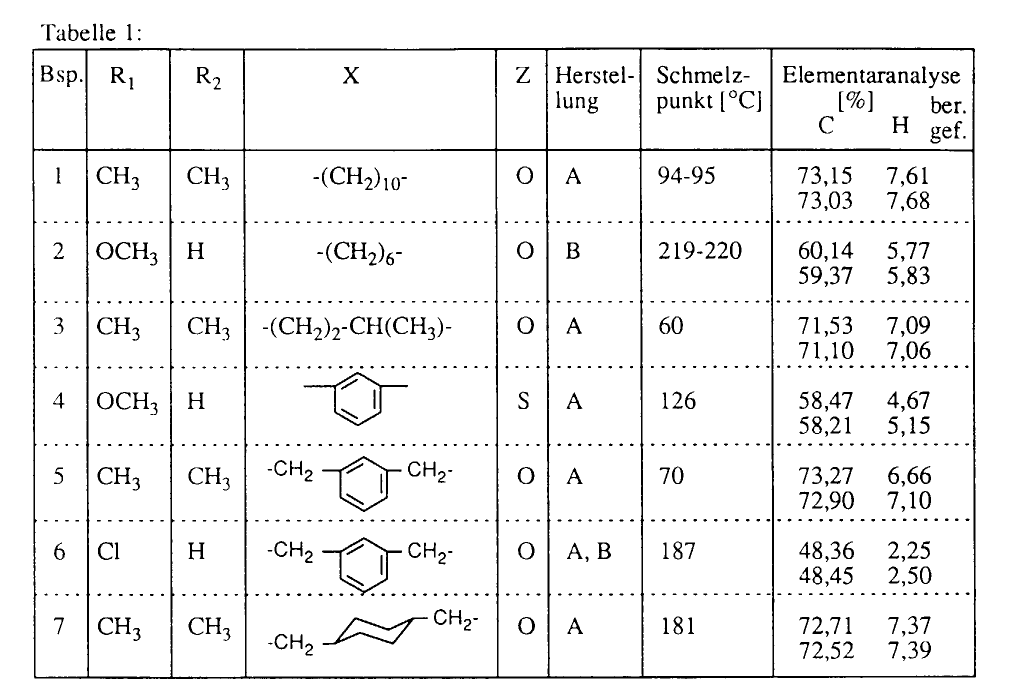

### Beispiel 8: Reaktivität in einem Polyesteracrylat-Weisslack

Ein UV-härtbarer Weisslack wird hergestellt durch Mischen von
- 67,5 Teilen: Polyesteracrylat Oligomer (®Ebecryl 830, UCB, Belgien)
- 5,0 Teilen: Hexandioldiacrylat
- 2,5 Teilen: Trimethylolpropantriacrylat
- 25,0 Teilen: Rutil-Titandioxid (®R-TC2, Tioxide, Frankreich)

Die zu testenden erfindungsgemässen Verbindungen werden dieser Formulierung in einer Konzentration von 2 Gew.-% eingearbeitet.
Der Lack wird mit einer 100 µm Spaltrakel auf ein coil-coated Aluminiumblech aufgetragen und anschliessend gehärtet. Die Härtung erfolgt, indem die Probe auf einem Förderband, welches mit einer Geschwindigkeit von 10 m/min bewegt wird, unter einer 80 W/cm Mitteldruck-Quecksilberlampe (Typ Hanovia, USA) durchgeführt wird. Ermittelt wird die Anzahl der zur Erreichung der Wischfestigkeit notwendigen Durchläufe. Danach wird die Pendelhärte nach König (DIN 53157) in [s] bestimmt. Die Pendelhärte ist ein Mass für die Durchhärtung der Zusammensetzung. Je höher die Werte, desto effektiver ist die erfolgte Härtung. Nach der ersten Pendelhärtebestimmung wurde unter 6 Lampen des Typs TL 40W/03 (Philips; Emissionsmaximum von 430 nm) nachbelichtet und nach 15 Minuten erneut die Pendelhärte bestimmt. Das Ergebnis ist in der Tabelle 2 wiedergegeben.

**Tabelle 2**

| Verb. aus Beispiel | Wischfestigkeit [x · 10m/min] | Pendelhärte | |
|---|---|---|---|
| | | sofort | nach 15 min |
| 1 | 2 | 113 | 163 |
| 3 | 3 | 118 | 146 |
| 5 | 3 | 118 | 133 |

### Beispiel 9: Reaktivität in einem Polyesteracrylat-Weisslack

Die Testmethode des Beispiels 8 wird wiederholt. Als Photoinitiator wird jedoch eine Mischung aus 75 % 1-Benzoyl-1-hydroxy-1-methyl-ethan und 25 % der Verbindung aus Beispiel 1 eingearbeitet. Die Ergebnisse sind der Tabelle 3 zu entnehmen.

**Tabelle 3**

| Wischfestigkeit [x · 10 m/min] | Pendelhärte | |
|---|---|---|
| | sofort | nach 15 min |
| 1 | 68 | 132 |

### Beispiel 10: Härtung eines Weisslacks

Es wird ein Weisslack bereitet aus 75 Teilen einer Formulierung aus:
- 99,5 %: ®Roskydal UV 502 A (Lösung eines ungesättigten Polyesters in Styrol, Bayer)
- 0,5 %: ®Byk 300 (Verlaufhilfsmittel, Byk-Mallinckrodt)
- 25.0 %: ®R-TC2 (Titandioxid, Tioxide)

Der Photoinitiator aus Beispiel 1 wird in einer Konzentration von 2 Gew.-% in diese Formulierung eingearbeitet. Die Formulierung wird mit einer 150 µm Spaltrakel auf Spanplatten aufgetragen. Vor der Härtung werden die beschichteten Platten eine Minute bei 22 °C gelagert. Danach erfolgt die Härtung bei einer Bandgeschwindigkeit von 6 m/min oder 3 m/min unter einer Lampenkombination von einer 120 W/cm Fusion D und einer 80 W/cm Mitteldruckquecksilberlampe (Typ Hanovia, USA). Anschliessend wird die Pendelhärte nach König bestimmt. Die Ergebnisse sind in der Tabelle 4 aufgelistet.

**Tabelle 4**

| Pendelhärte nach | |
|---|---|
| Härtung bei 6 m/min | Härtung bei 3 m/min |
| 62 | 110 |

### Beispiel 11: Härtung eines Weisslacks

Zu der Formulierung, wie sie in Beispiel 10 beschrieben ist, werden als Photoinitiator 2 Gew.-% einer Mischung aus 75 % 1-Benzoyl-1-hydroxy-1-methyl-ethan und 25 % der Verbindung aus Beispiel 1 eingearbeitet. Die Formulierung wird mit einer 150 µm Spaltrakel auf Spanplatten aufgetragen. Vor der Härtung wird die beschichtete Platte 1,5 min bei 22 °C gelagert und danach bei einer Bandgeschwindigkeit 3 m/min unter einer Lampenkombination von einer 120 W/cm Fusion D und einer 80 W/cm Mitteldruckquecksilberlampe (Typ Hanovia, USA) gehärtet. Die anschliessende Bestimmung der Pendelhärte nach König ergibt einen Wert von 61 s.

### Beispiel 12: Härtung eines Weisslacks mit Sonnenlicht

Die in Beispiel 10 beschriebene Zusammensetzung wird mit einer 150 µm Spaltrakel auf Spanplatten aufgetragen und dem Sonnenlicht ausgesetzt. Nach 10 Minuten wird eine klebfreie Oberfläche erhalten.

### Beispiel 13: Härtung von Formteilen aus einer Verbundmasse

Es wird eine Formulierung bereitet aus
- 98,0 Teilen: ungesättigtem Polyester/Styrol Roskydal 500A (Bayer, Deutschland)
- 1,5 Teilen: 1-Benzoyl-1-Hydroxy-1-methyl-ethan ®Darocur 1173 (Ciba, Schweiz)
- 0,5 Teilen: des erfindunsgemässen Photoinitiators (1) aus Beispiel 1, (2) aus Beispiel 3 und (3) aus Beispiel 5

Ein lockeres Glasfasergewebe als Matrixmaterial wird in eine Rohrform von 9 cm Durchmesser eingepasst und mit der Formulierung durchtränkt. Das Gewichtsverhältnis von Glasfasergewebe zu Formulierung beträgt 1:2. Durch Bestrahlung mit einer TL 40 W 03 Lampe (Philips) wird ausgehärtet. Es werden Formteile mit hoher mechanischer Stabilität und Belastbarkeit erhalten.

## Patentansprüche

1. Verbindungen der Formel I 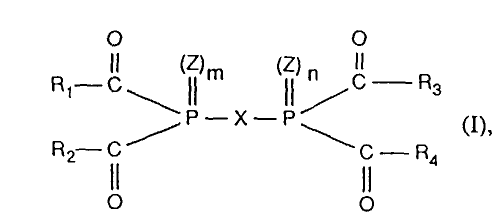 worin
Z für Sauerstoff oder Schwefel steht,
n und m unabhängig voneinander 0 oder 1 bedeuten,
R₁, R₂, R₃ und R₄ unabhängig voneinander für C₁-C₂₀-Alkyl, Cyclopropyl, Cyclopentyl, Cyclohexyl, C₂-C₈-Alkenyl, unsubstituiertes oder ein- bis vierfach mit C₁-C₁₂-Alkyl, C₁-C₁₂-Alkoxy, C₁-C₆-Alkylthio und/oder Halogen substituiertes Phenyl, unsubstituiertes oder ein- bis vierfach mit C₁-C₁₂-Alkyl, C₁-C₁₂-Alkoxy, C₁-C₆-Alkylthio und/oder Halogen substituiertes Naphthyl, unsubstituiertes oder ein- bis vierfach mit C₁-C₁₂-Alkyl, C₁-C₁₂-Alkoxy, C₁-C₆-Alkylthio und/oder Halogen substituiertes Biphenyl stehen, oder R₁, R₂, R₃ und R₄ unabhängig voneinander für einen O-, S- oder N-haltigen 5- oder 6-gliedrigen heterocyclischen Ring stehen oder R₁ und R₂ oder/und R₃ und R₄ zu einem 4 bis 10 Kohlenstoffatome enthaltenden Ring verknüpft sind, der unsubstituiert oder mit 1 bis 6 C₁-C₄-Alkylgruppen substituiert ist,
X für lineares oder verzweigtes C₁-C₁₈-Alkylen, ein- oder mehrmals durch -O-, -S-, -NR₅-, -P(O)R₆- oder -SO₂- unterbrochenes C₂-C₁₈-Alkylen, oder für mit Cl, F, C₁-C₄-Alkoxy, COOR₇, Phenyl, C₁-C₄-Alkyl-phenyl, C₁-C₄-Alkyl-naphthyl, Phenyl-C₁-C₄-alkyl, Naphthyl-C₁-C₄-alkyl, Phenyl-C₁-C₄-alkoxy, Naphthyl-C₁-C₄-alkoxy, C₁-C₄-Alkoxy-C₁-C₄-alkoxy und/oder CN substituiertes C₁-C₆-Alkylen steht, oder X C₂-C₈-Alkylen, welches mit einer oder zwei Gruppen der Formel G 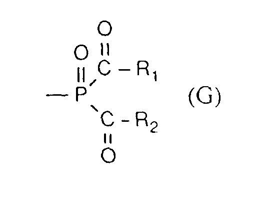 substituiert ist, bedeutet, oder X für eine Gruppe der Formel (II), (III), (IV), (V), (VI), (VII), (VIII), (IX) oder (X) 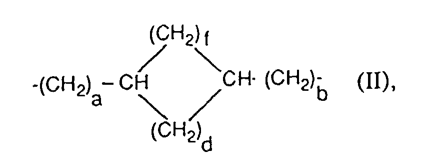 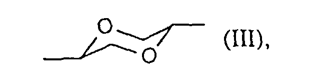 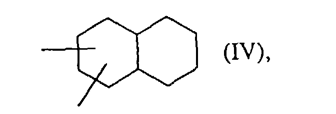 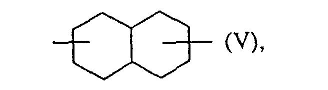 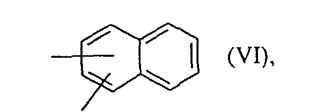 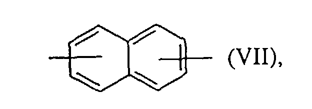 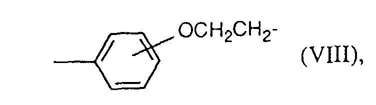 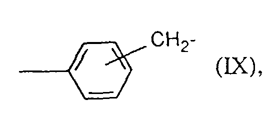 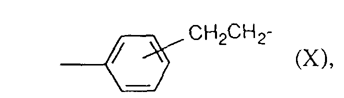 steht, worin
a und b unabhängig voneinander 0 oder 1 bedeuten,
die Summe von d und f 3 bis 8 ist, wobei weder d noch f 0 sind,
oder X eine Gruppe -CH₂-CH=CH-CH₂- oder -CH₂ ― C ≡ C ― CH₂- bedeutet, oder X für unsubstituiertes oder ein- bis dreifach mit Cl, F, C₁-C₄-Alkyl und/oder C₁-C₄-Alkoxy substituiertes Phenylen, Xylylen, 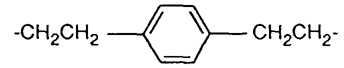 oder 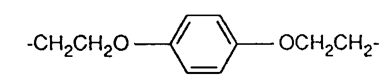 steht, oder X mit ein bis zwei Gruppen G substituiertes Phenylen ist, welches ausserdem noch ein- bis dreifach mit Cl, F, C₁-C₄-Alkyl und/oder C₁-C₄-Alkoxy substituiert sein kann, oder X eine Gruppe der Formel (XI), (XII), (XIII) oder (XIV) ist 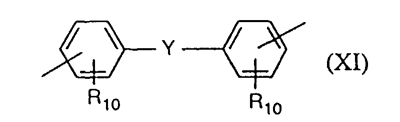 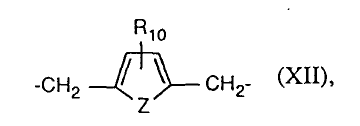 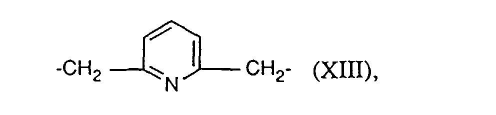 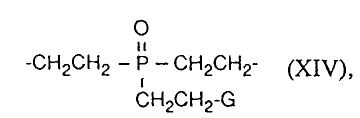 worin
Z und G wie oben definiert sind und
Y eine Einfachbindung, -CR₈R₉-, -O-, -NR₅-, -S-, -SO₂-, -(CH₂)ₚ- oder -CH=CH- ist,
p für eine Zahl von 2 bis 12 steht,
R₅ Wasserstoff, C₁-C₁₂-Alkyl oder Phenyl bedeutet,
R₆ C₁-C₄-Alkyl oder Phenyl ist,
R₇ für C₁-C₁₂-Alkyl, mit einem oder mehreren O unterbrochenes C₂-C₁₈-Alkyl, Benzyl, Phenyl, Cyclopentyl oder Cyclohexyl steht, und
R₈ Wasserstoff, Methyl oder Ethyl ist,
R₉ Wasserstoff oder C₁-C₄-Alkyl bedeutet und
R₁₀ für Wasserstoff C₁-C₄-Alkyl, C₁-C₄-Alkoxy oder Halogen steht.

2. Verbindungen der Formel I nach Anspruch 1, worin
R₁, R₂, R₃ und R₄ für tert-C₄-C₈-Alkyl, Cyclopentyl, Cyclohexyl, für einen Rest 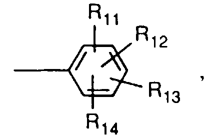 worin
R₁₁ C₁-C₈-Alkyl, C₁-C₈-Alkoxy, C₁-C₄-Alkylthio oder Halogen ist,
R₁₂, R₁₃ und R₁₄ unabhängig voneinander Wasserstoff, C₁-C₈-Alkyl, C₁-C₈-Alkoxy, C₁-C₄-Alkylthio oder Halogen sind, stehen oder R₁, R₂, R₃ und R₄ für unsubstituiertes oder ein- bis vierfach mit C₁-C₈-Alkyl, C₁-C₈-Alkoxy, C₁-C₄-Alkylthio und/oder Halogen substituiertes Naphthyl, unsubstituiertes oder ein- bis vierfach mit C₁-C₈-Alkyl, C₁-C₈-Alkoxy, C₁-C₄-Alkylthio und/oder Halogen substituiertes Biphenyl stehen, oder R₁, R₂, R₃ und R₄ unabhängig voneinander für einen O-, S- oder N-haltigen 5- oder 6-gliedrigen heterocyclischen Ring stehen oder R₁ und R₂ und R₃ und R₄ zu einem Benzolring verknüpft sind, wobei jeweils R₁ und R₂ sowie R₃ und R₄ ortho zueinander stehen,
X für lineares oder verzweigtes C₁-C₁₈-Alkylen, ein- oder mehrmals durch -O-, -S-, oder -SO₂- unterbrochenes C₄-C₁₈-Alkylen, oder für mit Cl, F, Methoxy, COOCH₃, Phenyl, C₁-C₄-Alkyl-phenyl oder Phenyl-C₁-C₄-alkyl substituiertes C₁-C₄-Alkylen steht, oder X C₂-C₈-Alkylen, welches mit einer oder zwei Gruppen der Formel G substituiert ist, bedeutet, oder X für eine Gruppe der Formel (II), (IX), (X) oder (XI) steht, oder X eine Gruppe -CH₂-CH=CH-CH₂- oder -CH₂-C≡C-CH₂- bedeutet, oder X für unsubstituiertes oder ein- bis dreifach mit Cl, F, C₁-C₄-Alkyl und/oder C₁-C₄-Alkoxy substituiertes Phenylen, Xylylen, 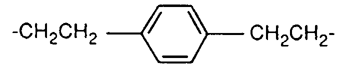 oder 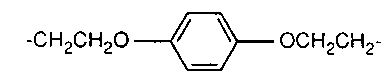 steht, oder X mit ein bis zwei Gruppen G substituiertes Phenylen ist, oder X eine Gruppe der Formel (XIV) darstellt,
Y eine Einfachbindung, -CR₈R₉-, -O-, -S-, -SO₂-, -CH₂CH₂- oder -CH=CH- ist und
R₈ und R₉ unabhängig voneinander Wasserstoff oder Methyl sind.

3. Verbindungen der Formel I nach Anspruch 1, worin
R₁, R₂, R₃ und R₄ für einen Rest 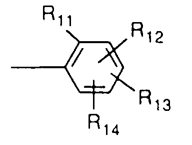 stehen, worin
R₁₁ C₁-C₄-Alkyl, C₁-C₄-Alkoxy, C₁-C₄-Alkylthio oder Halogen ist,
R₁₂, R₁₃ und R₁₄ unabhängig voneinander Wasserstoff, C₁-C₄-Alkyl, C₁-C₄-Alkoxy, C₁-C₄-Alkylthio oder Halogen sind, oder R₁, R₂, R₃ und R₄ für unsubstituiertes oder ein- bis vierfach mit C₁-C₄-Alkyl, C₁-C₄-Alkoxy, C₁-C₂-Alkylthio und/oder Halogen substituiertes Naphthyl, unsubstituiertes oder ein- bis vierfach mit C₁-C₄-Alkyl, C₁-C₄-Alkoxy, C₁-C₂-Alkylthio und/oder Halogen substituiertes Biphenyl stehen, X für lineares oder verzweigtes C₁-C₁₂-Alkylen, ein- oder mehrmals durch -O- oder -S-unterbrochenes C₄-C₁₈-Alkylen, oder für mit Cl, F, Methoxy, Phenyl oder Benzyl substituiertes C₁-C₄-Alkylen steht, oder X C₂-C₈-Alkylen, welches mit einer oder zwei Gruppen der Formel G substituiert ist, bedeutet, oder X für eine Gruppe 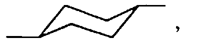 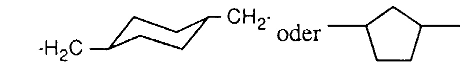 oder für eine Gruppe der Formel (IX'), (X') oder (XI') 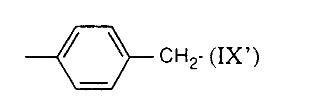 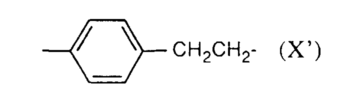 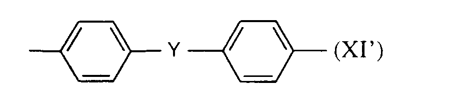 steht, oder X eine Gruppe -CH₂-CH=CH-CH₂- bedeutet, oder X für unsubstituiertes oder ein- bis dreifach mit Cl, F, C₁-C₄-Alkyl und/oder C₁-C₄-Alkoxy substituiertes Phenylen oder Xylylen steht, oder X mit ein bis zwei Gruppen G substituiertes Phenylen ist,
oder X eine Gruppe der Formel (XIV) darstellt,
Y eine Einfachbindung, -CR₈R₉-, -O-, -S- oder -CH₂CH₂- ist und
R₈ und R₉ unabhängig voneinander Wasserstoff oder Methyl sind.

4. Verbindungen der Formel I nach Anspruch 1, worin
R₁, R₂, R₃ und R₄ für einen Rest 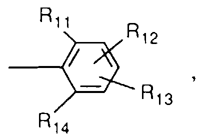 worin
R₁₁ und R₁₄ unabhängig voneinander C₁-C₄-Alkyl, C₁-C₄-Alkoxy, C₁-C₂-Alkylthio oder Halogen sind,
R₁₂ und R₁₃ unabhängig voneinander Wasserstoff, C₁-C₄-Alkyl, C₁-C₄-Alkoxy, C₁-C₂-Alkylthio oder Halogen sind,
X für lineares oder verzweigtes C₁-C₁₂-Alkylen, ein- oder mehrmals durch -O- oder -S- unterbrochenes C₄-C₁₄-Alkylen, C₂-C₈-Alkylen, welches mit einer oder zwei Gruppen der Formel G substituiert ist, eine Gruppe 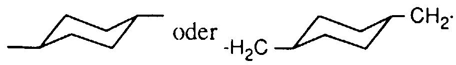 oder eine Gruppe der Formel (XI') steht, oder X eine Gruppe -CH₂-CH=CH-CH₂-, Phenylen oder Xylylen oder mit ein bis zwei Gruppen G substituiertes Phenylen ist, oder X eine Gruppe der Formel (XIV) darstellt,
Y eine Einfachbindung oder -CR₈R₉- ist und
R₈ und R₉ unabhängig voneinander Wasserstoff oder Methyl sind.

5. Verbindungen der Formel I nach Anspruch 1, worin
R₁, R₂, R₃ und R₄ eine Gruppe der Formel 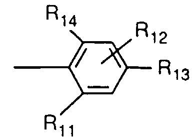 darstellen, worin
R₁₁ und R₁₄ unabhängig voneinander C₁-C₄-Alkyl, insbesondere Methyl, Methoxy oder Chlor bedeuten,
R₁₂ und R₁₃ unabhängig voneinander für C₁-C₄-Alkyl, insbesondere Methyl, C₁-C₄-Alkoxy, Chlor oder Wasserstoff stehen,
X für lineares oder verzweigtes C₁-C₁₂-Alkylen, ein- oder mehrmals durch -O- unterbrochenes C₄-C₁₈-Alkylen, C₃-C₆-Alkylen, welches mit einer oder zwei Gruppen der Formel G substituiert ist, steht, oder X eine Gruppe -CH₂-CH=CH-CH₂- oder unsubstituiertes oder mit einer oder zwei Gruppen der Formel G substituiertes Phenylen ist, oder X eine Gruppe 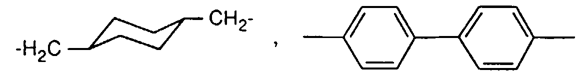 oder 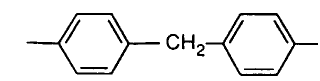 darstellt.

6. Verbindungen der Formel I nach Anspruch 5, worin R₁₂ Wasserstoff ist, und
X für lineares oder verzweigtes C₁-C₁₂-Alkylen, ein- oder mehrmals durch -O- unterbrochenes C₄-C₁₈-Alkylen, C₃-C₆-Alkylen, welches mit einer oder zwei Gruppen der Formel G substituiert ist, steht,
oder X eine Gruppe -CH₂-CH=CH-CH₂- , Phenylen oder Xylylen ist, oder X eine Gruppe 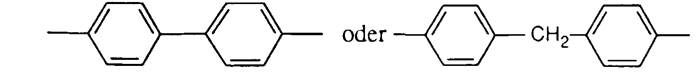 darstellt.

7. Verbindungen der Formel I nach Anspruch 6, worin X für lineares oder verzweigtes C₁-C₁₂-Alkylen, ein- oder mehrmals durch -O- unterbrochenes C₄-C₁₈-Alkylen steht, oder
X eine Gruppe -CH₂-CH=CH-CH₂-, Phenylen, Xylylen oder 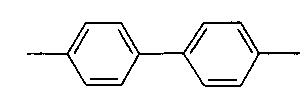 ist, oder X 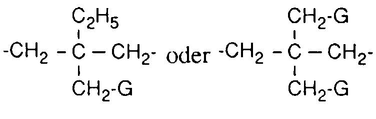 bedeutet.

8. Verbindungen nach einem der Ansprüche 1-7, worin R₁, R₂, R₃ und R₄ gleich sind.

9. Verbindungen nach einem der Ansprüche 1-8, worin Z Sauerstoff bedeutet und n und m 1 sind.

10. Verbindungen nach Anspruch 1, worin Z Sauerstoff bedeutet, n und m 1 sind, R₁, R₂, R₃ und R₄ gleich sind und zwei oder dreifach mit Methyl, Chlor oder Methoxy substituiertes Phenyl bedeuten und X C₄-C₁₂-Alkylen, 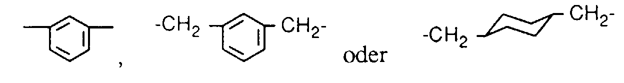 ist.

11. Photopolymerisierbare Zusammensetzung enthaltend
(a) mindestens eine ethylenisch ungesättigte photopolymerisierbare Verbindung und
(b) als Photoinitiator mindestens eine Verbindung der Formel I wie in Anspruch 1 definiert.

12. Zusammensetzung nach Anspruch 11 enthaltend neben der Komponente (b) noch andere Photoinitiatoren und/oder Additive.

13. Zusammensetzung nach Anspruch 12, worin als zusätzliches Additiv ein UV-Absorber aus der Klasse der Hydroxyphenyl-benztriazol-, Hydroxyphenyl-benzophenon-, Oxalsäureamid- oder Hydroxyphenyl-s-triazin-Verbindungen, gegebenenfalls in Gegenwart eines sterisch gehinderten Amins, zugesetzt wird.

14. Zusammensetzung nach Anspruch 12, worin die zusätzlichen Photoinitiatoren Verbindungen der Formel (XV) 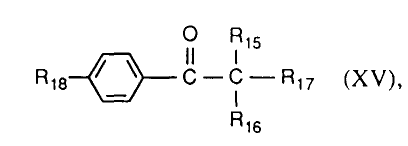 worin
R₁₈ für Wasserstoff, C₁-C₁₈-Alkyl, C₁-C₁₈-Alkoxy, -OCH₂CH₂-OR₁₉, eine Gruppe 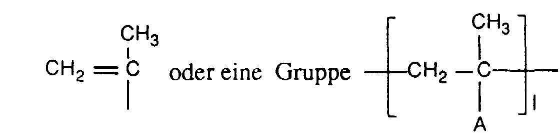 steht, worin
l einen Wert von 2 bis 10 hat und
A für den Rest 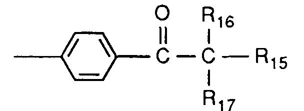 steht,
R₁₅ und R₁₆ unabhängig voneinander Wasserstoff, C₁-C₆-Alkyl, Phenyl, C₁-C₁₆-Alkoxy oder -O(CH₂CH₂O)_{q}-C₁-C₁₆-Alkyl, worin
q für eine Zahl von 1-20 steht, bedeuten, oder
R₁₅ und R₁₆ zusammen mit dem Kohlenstoffatom, an welches sie gebunden sind, einen Cyclohexylring bilden,
R₁₇ Hydroxy, C₁-C₁₆-Alkoxy oder -O(CH₂CH₂O)_{q}-C₁-C₁₆-Alkyl darstellt, wobei R₁₅, R₁₆ und R₁₇ nicht alle gleichzeitig C₁-C₁₆-Alkoxy oder -O(CH₂CH₂O)_{q}-C₁-C₁₆-Alkyl bedeuten, und
R₁₉ Wasserstoff, 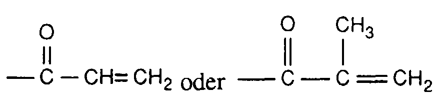 bedeutet,
und/oder worin die zusätzlichen Photoinitiatoren Verbindungen der Formel (XVI) 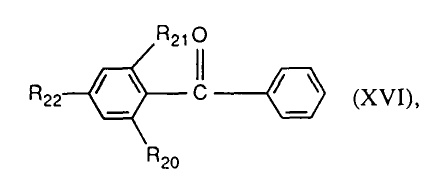 worin
R₂₀, R₂₁ und R₂₂ unabhängig voneinander Wasserstoff oder Methyl bedeuten, sind,
oder worin die zusätzlichen Photoinitiatoren Mischungen von Verbindungen der Formel (XV) und/oder (XVI) sind.

15. Zusammensetzung nach einem der Ansprüche 11-14, enthaltend 0,05-15, insbesondere 0,1-5 Gew.-% der Komponente (b), bezogen auf die Zusammensetzung.

16. Verwendung von in Anspruch 1 definierten Verbindungen der Formel I als Photoinitiatoren für die Photopolymerisation ethylenisch ungesättigter Verbindungen.

17. Verfahren zur Photopolymerisation von Verbindungen mit ethylenisch ungesättigten Doppelbindungen, dadurch gekennzeichnet, dass eine Zusammensetzung nach einem der Ansprüche 11-15 mit Licht im Bereich von 200 bis 600 nm bestrahlt wird.

18. Verwendung einer Zusammensetzung nach einem der Ansprüche 11-15 zur Herstellung von Anstrichstoffen, insbesondere Weisslacken für Holz- und Metallanstriche oder Klarlacken, zur Herstellung von buntpigmentierten Lacken, zur Herstellung von klaren oder pigmentierten wässrigen Dispersionen, zur Herstellung von Druckfarben, zur Herstellung von Pulverlacken, zur Herstellung von dreidimensionalen Gegenständen durch Massenhärtung oder Stereolithographie, zur Herstellung von Zahnfüllmassen, zur Herstellung von Druckplatten, zur Herstellung von Masken für den Siebdruck, zur Herstellung von Photoresists für gedruckte elektronische Schaltungen, zur Herstellung von Klebstoffen, als Ueberzug für optische Fasern oder als Beschichtung oder Versiegelung von elektronischen Bauteilen.

19. Verfahren nach Anspruch 17 zur Herstellung von Anstrichstoffen, insbesondere Weisslacken für Holz- und Metallanstriche oder Klarlacken, zur Herstellung von buntpigmentierten Lacken, zur Herstellung von klaren oder pigmentierten wässrigen Dispersionen, zur Herstellung von Druckfarben, zur Herstellung von Pulverlacken, zur Herstellung von Anstrichstoffen für tageslichthärtbare Bautenanstriche und Strassenmarkierungen, zur Herstellung von Zahnfüllmassen, zur Herstellung von Druckplatten, zur Herstellung von Masken für den Siebdruck, zur Herstellung von Photoresists für gedruckte elektronische Schaltungen, zur Herstellung von Klebstoffen, zur Herstellung von Ueberzugen für optische Fasern, zur Herstellung von Beschichtungen oder Versiegelungen von elektronischen Bauteilen.

20. Verwendung von Verbindungen der Formel I, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind, zur Härtung von Formteilen aus Verbundmassen.

21. Verfahren zur Härtung von Formteilen aus Verbundmassen dadurch gekennzeichnet, dass zur Härtung Verbindungen der Formel I, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind, verwendet werden.

22. Verfahren nach Anspruch 17, das nach der Methode der Massenhärtung oder Stereolithographie durchgeführt wird.

23. Verwendung von Verbindungen der Formel I nach Anspruch 5, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind zur Härtung von ethylenisch ungesättigten Verbindungen mit Tageslicht bzw. tageslichtäquivalenten Lichtquellen.

24. Verfahren zur Härtung von ethylenisch ungesättigten polymerisierbaren Verbindungen dadurch gekennzeichnet, dass man diesen mindestens einen Photoinitiator der Formel I nach Anspruch 5, worin R₁₁ und R₁₄ C₁-C₄-Alkyl bedeuten und R₁₂ und R₁₃ Wasserstoff, C₁-C₄-Alkyl, C₁-C₄-Alkoxy oder Chlor sind, zusetzt und mit Tageslicht bzw. tageslichtäquivalenten Lichtquellen bestrahlt.

25. Beschichtetes Substrat, das auf mindestens einer Oberfläche mit einer Zusammensetzung nach einem der Ansprüche 11-15 beschichtet ist.

26. Verfahren zur photographischen Herstellung von Reliefabbildungen, in welchem ein beschichtetes Substrat nach Anspruch 25 bildmässig belichtet wird und danach die unbelichteten Anteile mit einem Lösemittel entfernt werden.

## Claims

1. A compound of the formula I 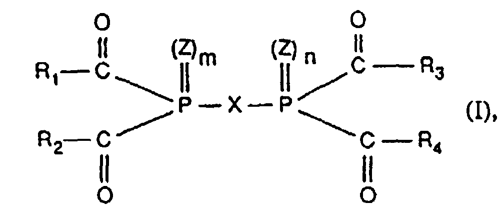 in which
Z is oxygen or sulfur,
n and m are independently of one another 0 or 1,
R₁, R₂, R₃ and R₄ independently of one another are C₁-C₂₀alkyl, cyclopropyl, cyclopentyl, cyclohexyl, C₂-C₈alkenyl, phenyl which is unsubstituted or is substituted one to four times by C₁-C₁₂alkyl, C₁-C₁₂alkoxy, C₁-C₆alkylthio and/or halogen, napththyl which is unsubstituted or is substituted one to four times by C₁-C₁₂alkyl, C₁-C₁₂alkoxy, C₁-C₆alkylthio and/or halogen, biphenyl which is unsubstituted or is substituted one to four times by C₁-C₁₂alkyl, C₁-C₁₂alkoxy, C₁-C₆alkylthio and/or halogen, or R₁, R₂, R₃ and R₄ independently of one another are a 5- or 6-membered heterocyclic ring which contains 0, S or N, or R₁ and R₂ or/and R₃ and R₄ are linked to form a ring containing 4 to 10 carbon atoms which is unsubstituted or is substituted by 1 to 6 C₁-C₄alkyl groups, X is linear or branched C₁-C₁₈alkylene, is C₂-C₁₈alkylene which is interrupted one or more times by -O-, -S-,-NR₅-, -P(O)R₆- or -SO₂-, or is C₁-C₆alkylene which is substituted by Cl, F, C₁-C₄alkoxy, COOR₇, phenyl, C₁-C₄alkylphenyl, C₁-C₄alkylnaphthyl, phenyl-C₁-C₄alkyl, naphthyl-C₁-C₄alkyl, phenyl-C₁-C₄alkoxy, naphthyl-C₁-C₄alkoxy, C₁-C₄alkoxy-C₁-C₄alkoxy and/or CN, or X is C₂-C₈alkylene which is substituted by one or two groups of the formula G 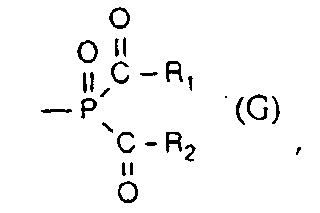 or X is a group of the formula (II), (III), (IV), (V), (VI), (VII), (VIII), (IX) or (X) 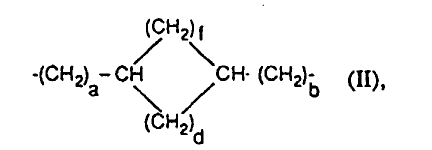 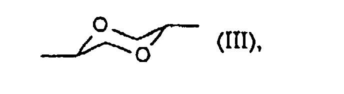 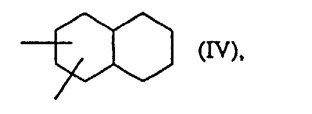 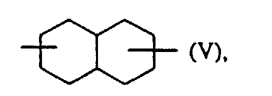 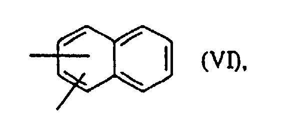 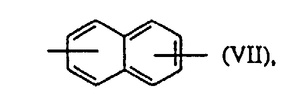 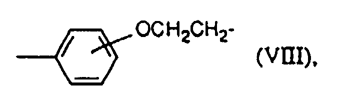 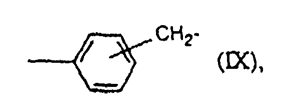 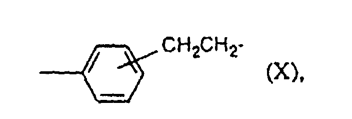 in which
a and b independently of one another are 0 or 1, the sum of d and f is 3 to 8, with neither d nor f being 0,
or X is a group -CH₂-CH=CH-CH₂- or -CH₂―C≡C―CH₂-, or X is phenylene which is unsubstituted or is substituted one to three times by Cl, F, C₁-C₄alkyl and/or C₁-C₄alkoxy, or is xylylene, 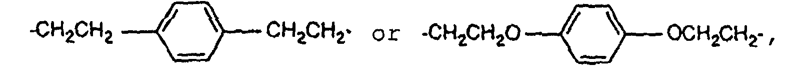 or X is phenylene wich is substituted by one or two groups G and which may also be substituted one to three times by Cl, F, C₁-C₄alkyl and/or C₁-C₄alkoxy, or X is a group of the formula (XI), (XII), (XIII) or (XIV) 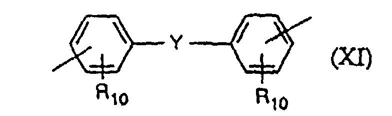 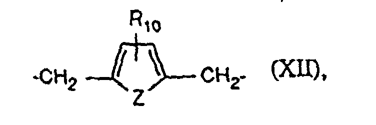 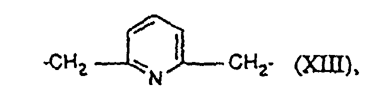 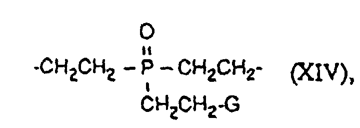 in which
Z and G are as defined above and
Y is a single bond, -CR₈R₉-, -O-, -NR₅-, -S-, -SO₂-, -(CH₂)ₚ or -CH=CH-,
p is a number from 2 to 12,
R₅ is hydrogen, C₁-C₁₂alkyl or phenyl,
R₆ is C₁-C₄alkyl or phenyl,
R₇ is C₁-C₁₂alkyl, C₂-C₁₈alkyl which is interrupted by one or more O atoms, or is benzyl, phenyl, cyclopentyl or cyclohexyl, and
R₈ is hdyrogen, methyl or ethyl,
R₉ is hdyrogen or C₁-C₄alkyl, and
R₁₀ is hydrogen, C₁-C₄alkyl, C₁-C₄alkoxy or halogen.

2. A compound of the formula I according to claim 1, in which R₁, R₂, R₃ and R₄ are tert-C₄-C₈alkyl, cyclopentyl, cyclohexyl or a radical 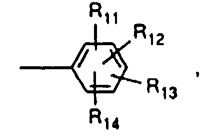 in which
R₁₁ is C₁-C₈alkyl, C₁-C₈alkoxy, C₁-C₄alkylthio or halogen,
R₁₂, R₁₃ and R₁₄ independently of one another are hydrogen, C₁-C₈alkyl, C₁-C₈alkoxy, C₁-C₄alkylthio or halogen, or R₁, R₂, R₃ and R₄ are naphthyl which is unsubstituted or is substituted one to four times by C₁-C₈alkyl, C₁-C₈alkoxy, C₁-C₄alkylthio and/or halogen, or are biphenyl which is unsubstituted or is substituted one to four times by C₁-C₈alkyl, C₁-C₈alkoxy, C₁-C₄alkylthio and/or halogen, or R₁, R₂, R₃ and R₄ independently of one another are a 5- or 6-membered heterocyclic ring containing O, S or N, or R₁ and R₂ and R₃ and R₄ are linked to form a benzene ring, in which R₁ and R₂, and R₃ and R₄, are in each case ortho to one another,
X is linear or branched C₁-C₁₈alkylene, is C₄-C₁₈alkylene which is interrupted one or more times by -O-, -S-, or -SO₂-, or is C₁-C₄alkylene which is substituted by Cl, F, methoxy, COOCH₃, phenyl, C₁-C₄alkyl-phenyl or phenyl-C₁-C₄alkyl, or X is C₂-C₈alkylene which is substituted by one or two groups of the formula G, or X is a group of the formula (II), (IX), (X) or (XI),
or X is a group -CH₂-CH=CH-CH₂- or -CH₂―C≡C―CH₂-,
or X is phenylene which is unsubstituted or is substituted one to three times by Cl, F, C₁-C₄alkyl and/or C₁-C₄alkoxy, or is xylylene, 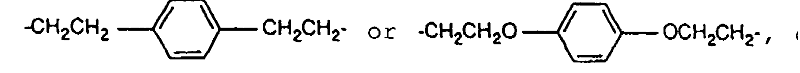 or X is phenylene substituted by one or two groups G, or X is a group of the formula (XIV).
Y is a single bond, -CR₈R₉-, -O-, -S-, -SO₂-, -CH₂CH₂ or -CH=CH- and R₈ and R₉ independently of one another are hydrogen or methyl.

3. A compound of the formula I according to claim 1, in which R₁, R₂, R₃ and R₄ are a radical 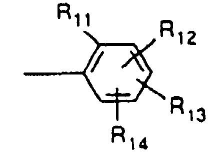 in which
R₁₁ is C₁-C₄alkyl, C₁-C₄alkoxy, C₁-C₄alkylthio or halogen,
R₁₂, R₁₃ and R₁₄ independently of one another are hydrogen, C₁-C₄alkyl, C₁-C₄alkoxy, C₁-C₄alkylthio or halogen, or R₁, R₂, R₃ and R₄ are naphthyl which is unsubstituted or is substituted one to four times by C₁-C₄alkyl, C₁-C₄alkoxy, C₁-C₂alkylthio and/or halogen, or are biphenyl which is unsubstituted or is substituted one to four times by C₁-C₄alkyl, C₁-C₄alkoxy, C₁-C₂alkylthio and/or halogen,
X is linear or branched C₁-C₁₂alkylene, is C₄-C₁₈alkylene which is interrupted one or more times by -O- or -S-, or is C₁-C₄alkylene which is substituted by Cl, F, methoxy, phenyl or benzyl, or X is C₂-C₈alkylene which is substituted by one or two groups of the formula G or
X is a group 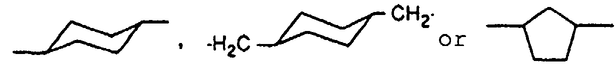 or is a group of the formula (IX'), (X') or (XI') 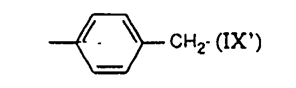 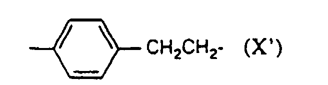 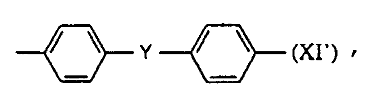 or X is a group -CH₂-CH=CH-CH₂-, or X is phenylene which is unsubstituted or is substituted one to three times by Cl, F, C₁-C₄alkyl and/or C₁-C₄alkoxy, or is xylylene, or X is phenylene which is substituted by one or two groups G,
or X is a group of the formula (XIV),
Y is a single bond, -CR₈R₉-, -O-, -S-, or -CH₂CH₂-, and
R₈ and R₉ independently of one another are hydrogen or methyl.

4. A compound of the formula I according to claim 1, in which R₁, R₂, R₃ and R₄ are a radical 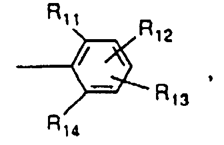 in which
R₁₁ and R₁₄ independently of one another are C₁-C₄alkyl, C₁-C₄alkoxy, C₁-C₂alkylthio or halogen,
R₁₂ and R₁₃ independently of one another are hydrogen, C₁-C₄alkyl, C₁-C₄alkoxy, C₁-C₂alkylthio or halogen, X is linear or branched C₁-C₁₂alkylene, C₄-C₁₄alkylene which is interrupted one or more times by -O- or -S-, or C₂-C₈alkylene which is substituted by one or two groups of the formula G, or is a group 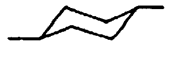 or 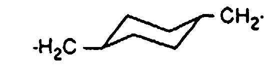 or a group of the formula (XI'),
or X is a group -CH₂-CH=CH-CH₂-, phenylene or xylylene or is phenylene substituted by one or two groups G,
or X is a group of the formula (XIV),
Y is a single bond, -CR₈R₉-, and
R₈ and R₉ independently of one another are hydrogen or methyl.

5. A compound of the formula I according to claim 1, in which R₁, R₂, R₃ and R₄ are a group of the formula 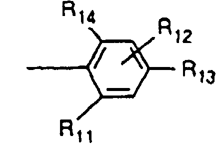 in which
R₁₁ and R₁₄ independently of one another are C₁-C₄alkyl, especially methyl, methoxy or chlorine,
R₁₂ and R₁₃ independently of one another are C₁-C₄alkyl, especially methyl, C₁-C₄alkoxy, chlorine or hydrogen, X is linear or branched C₁-C₁₂alkylene, is C₄-C₁₈alkylene which is interrupted one or more times by -O-, or C₃-C₆alkylene which is substituted by one or two groups of the formula G or X is a group -CH₂-CH=CH-CH₂- or is phenylene which is unsubstituted or is substituted by one or two groups of the formula G, or X is a group 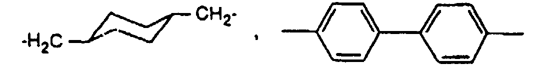 or

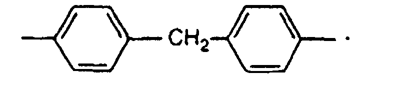

6. A compound of the formula I according to claim 5, in which
R₁₂ is hydrogen and
X is linear or branched C₁-C₁₂alkylene, C₄-C₁₈alkylene which is interrupted one or more times by -O-, or C₃-C₆alkylene which is substituted by one or two groups of the formula G,
or X is a group -CH₂-CH=CH-CH₂-, phenylene or xylylene,
or X is a group 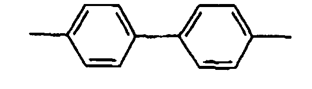 or

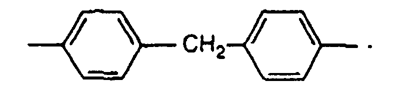

7. A compound of the formula I according to claim 6, in which X is linear or branched C₁-C₁₂alkylene or C₄-C₁₈alkylene which is interrupted one or more times by -O-, or X is a group -CH₂-CH=CH-CH₂-, phenylene, xylylene or 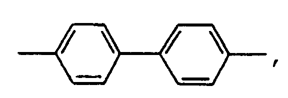 or X is 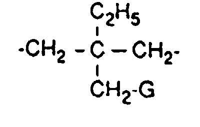 or

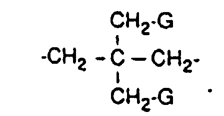

8. A compound according to any one of claims 1-7, in which R₁, R₂, R₃ and R₄ are identical.

9. A compound according to any one of claims 1-8, in which Z is oxygen and n and m are 1.

10. A compound according to claim 1, in which Z is oxygen, n and m are 1, R₁, R₂, R₃ and R₄ are identical and are phenyl which is disubstituted or trisubstituted by methyl, chlorine or methoxy and X is C₄-C₁₂alkylene,

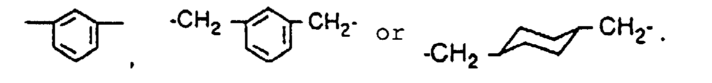

11. A photopolymerizable composition comprising
(a) at least one ethylenically unsaturated photopolymerizable compound, and
(b) as photoinitiator, at least one compound of the formula I as defined in claim 1.

12. A composition according to claim 11, comprising other photoinitiators and/or additives in addition to component (b) .

13. A composition according to claim 12, in which the additional additive is a UV absorber from the class of hydroxyphenylbenzotriazole, hydroxyphenylbenzophenone, oxalamide or hydroxyphenyl-s-triazine compounds, in the presence or absence of a sterically hindered amine.

14. A composition according to claim 12, in which the additional photoinitiators are compounds of the formula (XV) 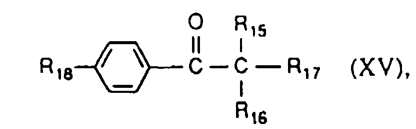 in which
R₁₈ is hydrogen, C₁-C₁₈alkyl, C₁-C₁₈alkoxy, -OCH₂CH₂-OR₁₉, a group 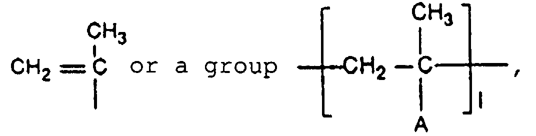 in which 1 has a value from 2 to 10 and
A is the radical 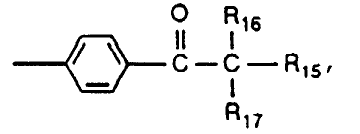
R₁₅ and R₁₆ independently of one another are hydrogen, C₁-C₆alkyl, phenyl, C₁-C₁₆alkoxy or -O(CH₂CH₂O)_{q}-C₁C₁₆alkyl in which
q is a number from 1-20, or
R₁₅ and R₁₆, together with the carbon atom to which they are attached, form a cyclohexyl ring,
R₁₇ is hydroxyl, C₁-C₁₆alkoxy or -O(CH₂CH₂)O_{q}-C₁-C₁₆alkyl,
R₁₅, R₁₆ and R₁₇ not all simultaneously being C₁-C₁₆alkoxy or -O(CH₂CH₂O)_{q}-C₁-C₁₆alkyl, and
R₁₉ is hydrogen, 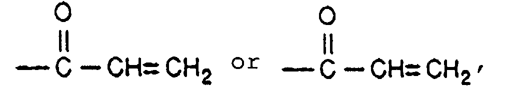 and/or in which the additional photoinitiators are compounds of the formula (XVI) 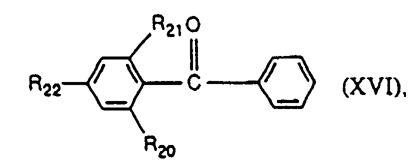 in which
R₂₀, R₂₁ and R₂₂ independently of one another are hydrogen or methyl, or in which the additional photoinitiators are mixtures of compounds of the formula (XV) and/or (XVI).

15. A composition according to any one of claims 11-14, comprising 0.05-15% by weight, in particular 0.1-5% by weight, of component (b), based on the composition.

16. The use of a compound of the formula I defined in claim 1 as a photoinitiator for the photopolymerization of ethylenically unsaturated compounds.

17. A method for the photopolymerization of compounds containing ethylenically unsaturated double bonds, which comprises irradiating a composition according to any one of claims 11-15 with light in the range from 200 to 600 nm.

18. The use of a composition according to any one of claims 11-15 for the production of coating substances, in particular white paints for wood coatings and metal coatings, or clear coating materials, for the production of coating materials pigmented with coloured pigments, for the production of clear or pigmented aqueous dispersions, for the production of printing inks, for the production of powder coatings, for the production of three-dimensional articles by bulk-curing or stereolithography, for the production of dental filling compositions, for the production of printing plates, for the production of masks for screen printing, for the production of photoresists for printed electronic circuits, for the production of adhesives, as a coating for optical fibres or as a coating or encapsulation of electronic components.

19. A method according to claim 17 for the production of coating substances, especially white paints for wood coatings and metal coatings, or clear coating materials, for the production of coating materials which are pigmented with coloured pigments, for the production of clear or pigmented aqueous dispersions, for the production of printing inks, for the production of powder coatings, for the production of coating substances for daylight-curable constructional coatings and road markings, for the production of dental filling compositions, for the production of printing plates, for the production of masks for screen printing, for the production of photoresists for printed electronic circuits, for the production of adhesives, for the production of coatings for optical fibres, for the production of coatings or encapsulations of electronic components.

20. The use of a compound of the formula I in which R₁₁ and R₁₄ are C₁-C₄alkyl and R₁₂ and R₁₃ are hydrogen, C₁-C₄alkyl, C₁-C₄alkoxy or chlorine for the curing of shaped parts made from composite compositions.

21. A method for the curing of shaped parts made from composite compositions, which comprises using a compound of the formula I in which R₁₁ and R₁₄ and C₁-C₄alkyl and R₁₂ and R₁₃ are hydrogen, C₁-C₄alkyl, C₁-C₄alkoxy or chlorine for the curing.

22. A method according to claim 17, which is carried out by the method of bulk curing or stereolithography.

23. The use of a compound of the formula I according to claim 5, in which R₁₁ and R₁₄ are C₁-C₄alkyl and R₁₂ and R₁₃ are hydrogen, C₁-C₄alkyl, C₁-C₄alkoxy or chlorine for the curing of ethylenically unsaturated compounds using daylight and/or daylight-equivalent light sources.

24. A method of curing ethylenically unsatured polymerizable compounds, which comprises adding to these compounds at least one photoinitator of the formula I according to claim 5, in which R₁₁ and R₁₄ are C₁-C₄alkyl and R₁₂ and R₁₃ are hydrogen, C₁-C₄alkyl, C₁-C₄alkoxy or chlorine, and irradiating the compositions with daylight and/or daylight-equivalent light sources.

25. A coated substrate which is coated on at least one surface with a composition according to any one of claims 11-15.

26. A process for the photographic production of relief images, in which a coated substrate according to claim 25 is subjected to imagewise exposure and then the unexposed areas are removed with a solvent.

## Revendications

1. Composés de formule I 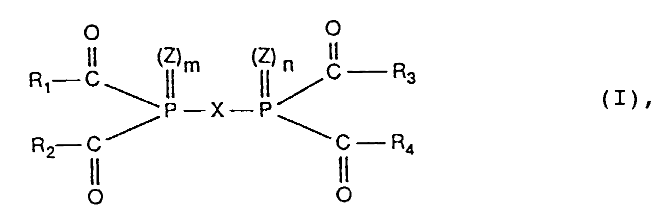 où
Z représente un atome d'oxygène ou de soufre,
n et m valent, indépendamment l'un de l'autre, 0 ou 1,
R₁, R₂, R₃ et R₄ représentent, indépendamment les uns des autres, des groupes alkyle en C₁-C₂₀, cyclopropyle, cyclopentyle, cyclohexyle, alcényle en C₂-C₈, phényle non substitué ou substitué 1 à 4 fois par des substituants alkyle en C₁-C₁₂, alkoxy en C₁-C₁₂, (alkyl en C₁-C₆)thio et/ou halogène, naphtyle non substitué ou substitué 1 à 4 fois par des substituants alkyle en C₁-C₁₂, alkoxy en C₁-C₁₂, (alkyl en C₁-C₆)thio et/ou halogène, biphényle non substitué ou substitué 1 à 4 fois par des substituants alkyle en C₁-C₁₂, alkoxy en C₁-C₁₂, (alkyl en C₁-C₆)thio et/ou halogène, ou R₁, R₂, R₃ et R₄ représentent, indépendamment les uns des autres, un cycle hétérocyclique à 5 ou 6 chaînons comportant des atomes d'oxygène, de soufre ou d'azote, ou R₁ et R₂, ou/et R₃ et R₄ sont reliés à un cycle présentant de 4 à 10 atomes de carbone, qui est non substitué ou substitué par 1 à 6 groupes alkyle en C₁-C₄,
X représente un groupe alkylène en C₁-C₁₈ linéaire ou ramifié,
un groupe alkylène en C₂-C₁₈ interrompu une ou plusieurs fois par des groupes -O-, -S-, -NR₅-, -P(O)R₆- ou -SO₂-, ou
un groupe alkylène en C₁-C₆ substitué par des substituants Cl, F, alkoxy en C₁-C₄, COOR₇, phényle, (alkyl en C₁-C₄)phényle, (alkyl en C₁-C₄)-naphtyle, phénylalkyle en C₁-C₄, naphtylalkyle en C₁-C₄, phénylalkoxy en C₁-C₄, naphtylalkoxy en C₁-C₄, (alkoxy en C₁-C₄)-alkoxy en C₁-C₄ et/ou CN, ou
X représente un groupe alkylène en C₂-C₈ lequel est substitué par un ou deux groupes de formule G 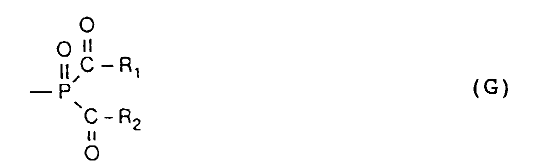 ou X représente un groupe de formule (II), (III), (IV), (V), (VI), (VII), (VIII), (IX) ou (X) 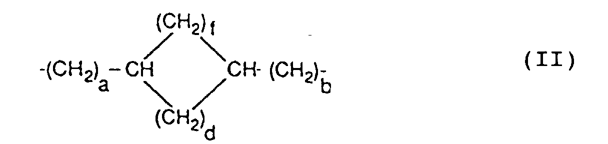 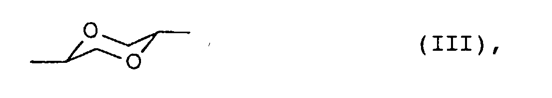 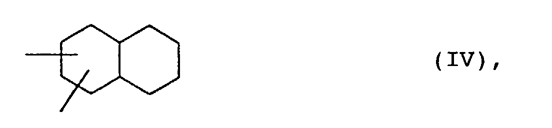 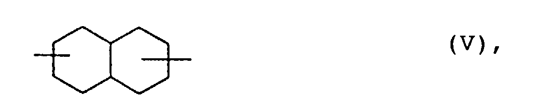 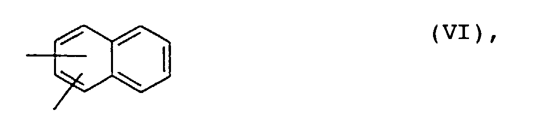 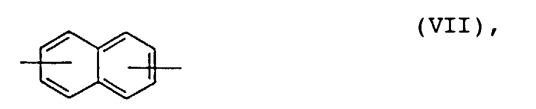 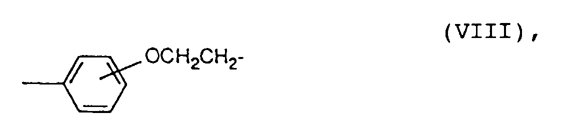 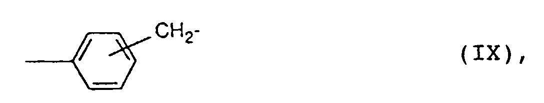 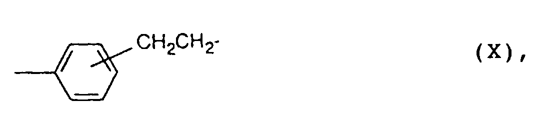
où
a et b valent, indépendamment l'un de l'autre, 0 ou 1, la somme de d et de f est de 3 à 8, ni d ni f n'étant pas égaux à 0, ou
X représente un groupe -CH₂-CH=CH-CH₂- ou -CH₂-C≡C-CH₂-, ou X représente des groupes 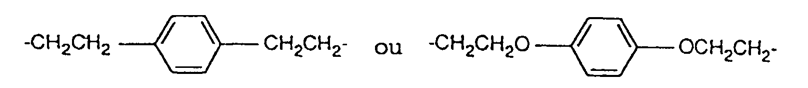 xylylène, phénylène non substitué ou substitué 1 à 3 fois par des substituants Cl, F, alkyle en C₁-C₄ et/ou alkoxy en C₁-C₄, ou
X représente un groupe phénylène substitué par un ou deux groupes G, lequel peut par ailleurs être substitué 1 à 3 fois par des substituants Cl, F, alkyle en C₁-C₄ et/ou alkoxy en C₁-C₄, ou
X représente un groupe de formule (XI), (XII), (XIII) ou (XIV) 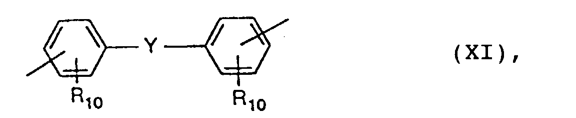 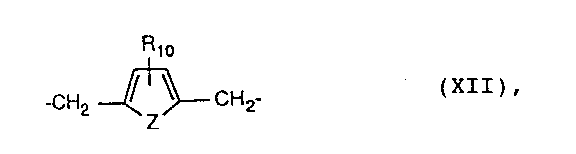 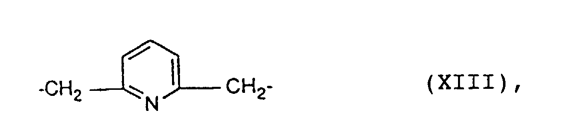 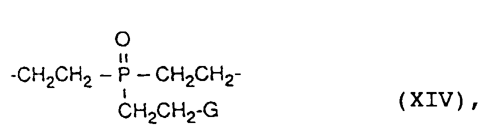 où
Z et G sont définis comme ci-dessus et
Y représente une simple liaison, des groupes -CR₈R₉-, -O-, -NR₅-, -S-, -SO₂-, -(CH₂)p- ou -CH=CH-,
p va de 2 à 12,
R₅ représente un atome d'hydrogène, un groupe alkyle en C₁-C₁₂ ou phényle,
R₆ représente un groupe alkyle en C₁-C₄ ou phényle,
R₇ des groupes alkyle en C₁-C₁₂, benzyle, phényle, cyclopentyle, cyclohexyle ou alkyle en C₂-C₁₈ interrompu par un ou plusieurs atomes d'oxygène,
R₈ représente un atome d'hydrogène, un groupe méthyle ou éthyle,
R₉ représente un atome d'hydrogène ou un groupe alkyle en C₁-C₄ et
R₁₀ représente un atome d'hydrogène, des groupes alkyle en C₁-C₄, alkoxy en C₁-C₄ ou halogène.

2. Composés de formule I selon la revendication 1, où R₁, R₂, R₃ et R₄ représentent des groupes tert.-alkyle en C₄-C₁₈, cyclopentyle, cyclohexyle, un reste 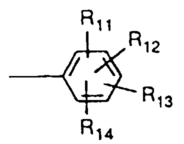 où
R₁₁ représente des groupes alkyle en C₁-C₈, alkoxy en C₁-C₈, (alkyl en C₁-C₄)thio ou halogène,
R₁₂, R₁₃ et R₁₄ représentent, indépendamment les uns des autres, des atomes d'hydrogène, des groupes alkyle en C₁-C₈, alkoxy en C₁-C₈, (alkyl en C₁-C₄)thio ou halogène, ou
R₁, R₂, R₃ et R₄ représentent un groupe naphtyle non substitué ou substitué 1 à 4 fois par des substituants alkyle en C₁-C₈, alkoxy en C₁-C₈, (alkyl en C₁-C₄)thio et/ou halogène, ou un groupe biphényle non substitué ou substitué 1 à 4 fois par des substituants alkyle en C₁-C₈, alkoxy en C₁-C₈, (alkyl en C₁-C₄)thio et/ou halogène, ou
R₁, R₂, R₃ et R₄ représentent, indépendamment les uns des autres, un hétérocycle de 5 ou 6 chaînons, présentant des atomes d'oxygène, de soufre ou d'azote, ou
R₁ et R₂ et R₃ et R₄ sont reliés à un cycle benzénique,
R₁ et R₂ et R₃ et R₄ sont chaque fois en position ortho l'un par rapport à l'autre,
X représente un groupe alkylène en C₁-C₁₈ linéaire ou ramifié, un groupe alkylène en C₄-C₁₈ interrompu une ou plusieurs fois par des groupes -O-, -S- ou -SO₂-, un groupe alkylène en C₁-C₄ substitué par des substituants Cl, F, méthoxy, COOCH₃, phényle, (alkyl en C₁-C₄)phényle ou phénylalkyle en C₁-C₄, ou
X représente un groupe alkylène en C₂-C₁₈ qui est substitué par un ou deux groupes de formule G, ou X représente un groupe de formule (II), (IX), (X) ou (XI), ou
X représente des groupes -CH₂CH=CH-CH₂- ou -CH₂-C≡C-CH₂-, ou
X représente des groupes 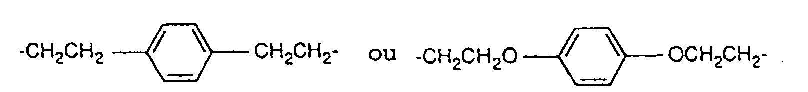 xylylène, phénylène non substitué ou substitué 1 à 3 fois par des substituants Cl, F, alkyle en C₁-C₄ et/ou alkoxy en C₁-C₄, ou
X représente un groupe phénylène substitué par un ou deux groupes G, ou
X représente un groupe de formule (XIV),
Y représente une simple liaison, des groupes -CR₈R₉-, -O-, -S-, -SO₂-, -CH₂-CH₂- ou -CH=CH- et
R₈ et R₉ représentent, indépendamment l'un de l'autre, un atome d'hydrogène ou un groupe méthyle.

3. Composés de formule I selon la revendication 1, où R₁, R₂, R₃ et R₄ représentent un reste 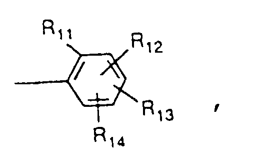 où
R₁₁ représente des groupes alkyle en C₁-C₄, alkoxy en C₁-C₄, (alkyl en C₁-C₄)thio ou halogène,
R_{12,} R₁₃ et R₁₄ représentent, indépendamment les uns des autres, des atomes d'hydrogène, des groupes alkyle en C₁-C₄, alkoxy en C₁-C₄, (alkyl en C₁-C₄)thio ou halogène, ou
R₁, R₂ R₃ et R₄ représentent un groupe naphtyle non substitué ou substitué 1 à 4 fois par des substituants alkyle en C₁-C₄, alkoxy en C₁-C₄, (alkyl en C₁-C₂)thio et/ou halogène, un groupe biphényle non substitué ou substitué 1 à 4 fois par des substituants alkyle en C₁-C₄, alkoxy en C₁-C₄, (alkyl en C₁-C₂)thio et/ou halogène,
X représente un groupe alkylène en C₁-C₁₂ linéaire ou ramifié, un groupe alkylène en C₄-C₁₈ interrompu une ou plusieurs fois par des atomes -O- ou -S- ou un groupe alkylène en C₁-C₄ substitué par des substituants Cl, F, méthoxy, phényle ou benzyle, ou
X représente un groupe alkylène en C₂-C₈ qui est substitué par un ou deux groupes de formule G, ou
X représente un groupe 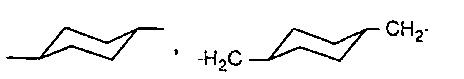 ou 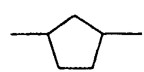 ou un groupe de formule (IX'), (X') ou (XI') 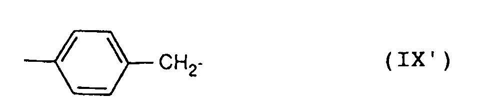 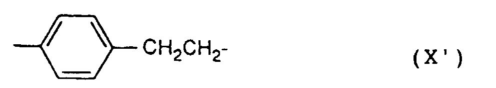 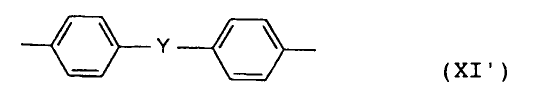 ou X représente un groupe -CH₂-CH=CH-CH₂-, ou
X représente un groupe xylylène ou phénylène non substitué ou substitué 1 à 3 fois par des substituants Cl, F, alkyle en C₁-C₄ et/ou alkoxy en C₁-C₄, ou
X représente un groupe phénylène substitué par un ou deux groupes G, ou
X représente un groupe de formule (XIV),
Y représente une simple liaison, des groupes -CR₈R₉-, -O-, -S- ou -CH₂-CH₂- et
R₈ et R₉ représentent, indépendamment l'un de l'autre, un atome d'hydrogène ou un groupe méthyle.

4. Composés de formule I selon la revendication 1, où
R₁, R₂, R₃ et R₄ représentent un reste 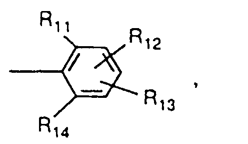 où
R₁₁ et R₁₄ représentent, indépendamment l'un de l'autre, des groupes alkyle en C₁-C₄, alkoxy en C₁-C₄, (alkyl en C₁-C₂)thio ou halogène,
R₁₂ et R₁₃ représentent, indépendamment les uns des autres, un atome d'hydrogène, des groupes alkyle en C₁-C₄, alkoxy en C₁-C₄, (alkyl en C₁-C₂)thio ou halogène,
X représente un groupe alkylène en C₁-C₁₂ linéaire ou ramifié, un groupe alkylène en C₄-C₁₄ interrompu une ou plusieurs fois par des atomes de -O- ou -S-, un groupe alkylène en C₂-C₈ substitué par un ou deux groupes de formule G, un groupe 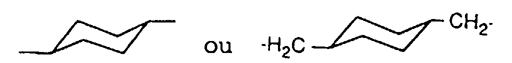 ou un groupe de formule (XI') ou
X représente un groupe de formule -CH₂-CH=CH-CH₂-, xylylène ou phénylène ou un groupe phénylène substitué par un ou deux groupes de formule G, ou
X représente un groupe de formule (XIV),
Y représente une simple liaison ou -CR₈R₉-,
R₈ et R₉ représentent, indépendamment l'un de l'autre, un atome d'hydrogène ou un groupe méthyle.

5. Composés de formule I selon la revendication 1, où R₁, R₂, R₃ et R₄ représentent un groupe de formule 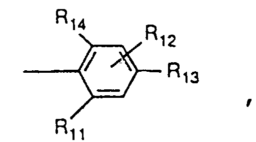 où
R₁₁ et R₁₄ représentent, indépendamment l'un de l'autre, des groupes alkyle en C₁-C₄, en particulier méthyle, méthoxy ou chloro,
R₁₂ et R₁₃ représentent, indépendamment l'un de l'autre, des groupes alkyle en C₁-C₄, en particulier méthyle, alkoxy en C₁-C₄, chloro ou hydrogène,
X représente un groupe alkylène en C₁-C₁₂ linéaire ou ramifié, un groupe alkylène en C₄-C₁₈ interrompu une ou plusieurs fois par des atomes de -O-, un groupe alkylène en C₃-C₆ substitué par un ou deux groupes de formule G, ou
X représente un groupe -CH₂-CH=CH-CH₂- ou phénylène non substitué ou substitué par un ou deux groupes de formule G, ou
X représente un groupe

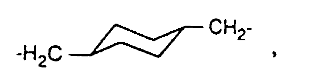

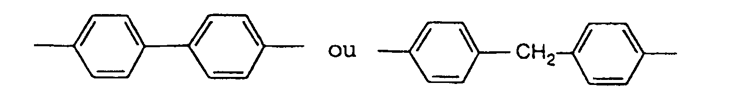

6. Composés de formule I selon la revendication 5, où
R₁₂ représente un atome d'hydrogène, et
X représente un groupe alkylène en C₁-C₁₂ linéaire ou ramifié, alkylène en C₄-C₁₈ interrompu une ou plusieurs fois par des atomes de -O-, un groupe alkylène en C₃-C₆ substitué par un ou deux groupes de formule G, ou
X représente un groupe -CH₂-CH=CH-CH₂-, phénylène ou xylylène, ou
X représente un groupe

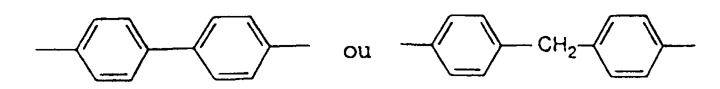

7. Composés de formule I selon la revendication 6, où
X représente un groupe alkylène en C₁-C₁₂ linéaire ou ramifié, alkylène en C₄-C₁₈ interrompu une ou plusieurs fois par -O-, ou
X représente des groupes -CH₂-CH=CH-CH₂-, phénylène, xylylène ou 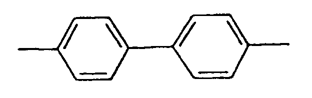
ou X représente

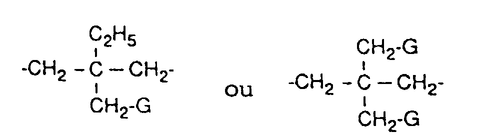

8. Composés selon l'une des revendications 1 à 7, où R₁, R₂, R₃ et R₄ sont identiques.

9. Composés selon l'une des revendications 1 à 8, où Z représente un atome d'oxygène et n et m valent 1.

10. Composés selon la revendication 1 où
Z représente un atome d'oxygène,
n et m valent 1 et
R₁, R₂, R₃ et R₄ sont identiques et représente un groupe phényle substitué 1 à 3 fois par des substituants méthyle, chloro ou méthoxy et
X représente un groupe alkylène en C₄-C₁₂,

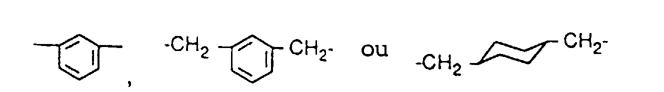

11. Composition photopolymérisable contenant
(a) au moins un composé à insaturation éthylénique et
(b) en tant que photoamorceur, au moins un composé de formule I comme définie à la revendication 1.

12. Composition selon la revendication 11 contenant, outre le constituant (b), encore d'autres photoamorceurs et/ou additifs.

13. Composition selon la revendication 12, où on ajoute, en tant qu'additif supplémentaire, un absorbeur UV de la famille des composés de hydroxyphénylbenzotriazole, hydroxyphényl-benzophénone, oxalamide ou hydroxyphényl-s-triazine, éventuellement en présence d'une amine à encombrement stérique.

14. Compositions selon la revendication 12 où les photoamorceurs supplémentaire représentent des composés de formule (XV) 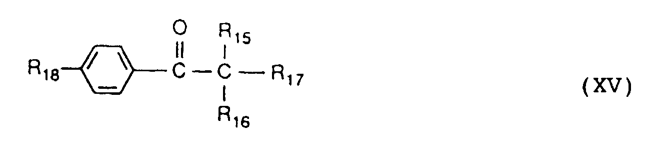 où
R₁₈ représente un atome d'hydrogène, des groupes alkyle en C₁-C₁₈, alkoxy en C₁-C₁₈, -OCH₂CH₂-OR₁₉, un groupe 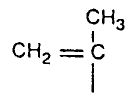 ou un groupe 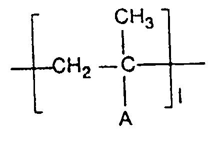 où l va de 2 à 10 et
A représente le reste 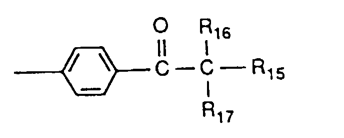
R₁₅ et R₁₆ représentent, indépendamment l'un de l'autre, des atomes d'hydrogène, des groupes alkyle en C₁-C₆, phényle, alkoxy en C₁-C₁₆ ou -O(CH₂CH₂O)_{q}-alkyle en C₁-C₆, où
q va de 1 à 20, ou
R₁₅ et R₁₆ forment, ensemble avec l'atome de carbone auquel ils sont liés, un cycle cyclohexyle,
R₁₇ représente des groupes hydroxy, alkoxy en C₁-C₁₆ ou -O(CH₂CH₂O)_{q}-alkyle en C₁-C₆,
R₁₅, R₁₆ et R₁₇ ne représentant pas simultanément des groupes alkoxy en C₁-C₁₆ ou -O(CH₂CH₂O)_{q}-alkyle en C₁-C₆, et
R₁₉ représente un atome d'hydrogène, 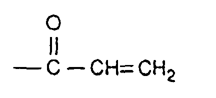 ou 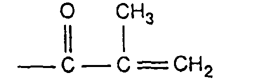 et/ou dans lesquels les photoamorceurs supplémentaires représentent des composés de formule (XVI) 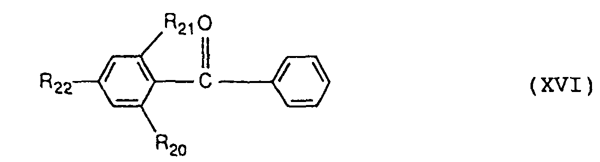 où R₂₀, R₂₁ et R₂₂ représentent, indépendamment l'un de l'autre, des atomes d'hydrogène ou des groupes méthyle, ou dans lesquelles les photoamorceurs supplémentaires sont des mélanges de composés de formules (XV) et/ou (XVI).

15. Composition selon l'une des revendications 11 à 14, ayant une teneur de 0,05 à 15, en particulier de 0,1 à 5% massiques, en constituant (b), par rapport à la composition.

16. Utilisation des composés de formule I définis à la revendication 1, en tant que photoamorceurs pour la polymérisation de composés à insaturation éthylénique.

17. Procédé de photopolymérisation de composés présentant des doubles liaisons à insaturation éthylénique, caractérisé en ce qu'on irradie une composition selon l'une des revendications 11 à 15 par une lumière dans le domaine de 200 à 600 nm.

18. Utilisation d'une composition selon l'une des revendications 11 à 15 pour préparation de peintures, en particulier de vernis blancs pour le revêtement de bois ou de métaux ou de vernis clairs, pour la préparation de laques à pigment colorés, pour la préparation de dispersions aqueuses claires ou pigmentées, pour la préparation d'encres d'impression, pour la préparation de vernis en poudre, pour la préparation d'objets tridimensionnels par durcissement en masse ou par stéréolithographie, pour la préparation de matières dentaires, pour la préparation de clichés d'imprimerie, pour la préparation de masques de sérigraphie, pour la préparation de photorésists pour circuits électroniques imprimés, pour la préparation d'adhésifs ou de revêtements de fibres optiques ou de revêtements ou de scellements de composants électroniques.

19. Procédé selon la revendication 17 pour la préparation de peintures, en particulier de vernis blancs pour le revêtement de bois ou de métaux ou de vernis clairs, pour la préparation de laques à pigments colorés, pour la préparation de dispersions aqueuses claires ou pigmentées, pour la préparation d'encres d'impression, pour la préparation de vernis en poudre, pour la préparation de peintures durcissables à la lumière du jour pour marquage de bâtiment et de chaussées, pour la préparation de matières dentaires, pour la préparation de clichés d'imprimerie, pour la préparation de masques de sérigraphie, pour la préparation de photorésists pour circuits électroniques imprimés, pour la préparation d'adhésifs, pour la préparation de revêtements de fibres optiques, pour la préparation de revêtements ou de scellements de composants électroniques.

20. Utilisation de composés de formule I, où R₁₁ et R₁₄ représentent un groupe alkyle en C₁-C₄ et R₁₂ et R₁₃ représentent des atomes d'hydrogène, des groupes alkyle en C₁-C₄, alkoxy en C₁-C₄ ou chloro, pour le durcissement de préformés en matériaux composites.

21. Procédé de durcissement de préformés en matériaux composites caractérisé en ce qu'on utilise pour le durcissement de composés de formule I, où R₁₁ et R₁₄ représentent un groupe alkyle en C₁-C₄ et R₁₂ et R₁₃ représentent des atomes d'hydrogène, des groupes alkyle en C₁-C₄, alkoxy en C₁-C₄ ou chloro.

22. Procédé selon la revendication 17, mis en oeuvre selon la méthode de durcissement en masse ou par stéréolithographie.

23. Utilisation des composés de formule I selon la revendication 5, où R₁₁ et R₁₄ représentent un groupe alkyle en C₁-C₄ et R₁₂ et R₁₃ représentent des atomes d'hydrogène, des groupes alkyle en C₁-C₄, alkoxy en C₁-C₄ ou chloro, pour le durcissement de composés à insaturation éthylénique par la lumière du jour ou des sources de lumière équivalent à la lumière du jour.

24. Procédé pour le durcissement de composés à insaturation éthylénique caractérisé en ce qu'on leur ajoute au moins un photoamorceur de formule I selon la revendication 5, où R₁₁ et R₁₄ représentent un groupe alkyle en C₁-C₄ et R₁₂ et R₁₃ représentent des atomes d'hydrogène, des groupes alkyle en C₁-C₄, alkoxy en C₁-C₄ ou chloro et on irradie par la lumière du jour ou des sources de lumière équivalent à la lumière du jour.

25. Substrat revêtu, lequel est revêtu sur au moins une surface d'une composition selon l'une des revendications 11 à 15.

26. Procédé pour la préparation photographique de reproductions en relief dans lequel on irradie selon un modèle un substrat revêtu selon la revendication 25 et ensuite on élimine les portions non irradiées à l'aide d'un solvant.
